# FASCICULE DE BREVET EUROPEEN

(11) **EP 4 507 004 B1**
(45) Date de publication et mention de la délivrance du brevet: **25.03.2026**
(21) Numéro de dépôt: 24193010.6
(22) Date de dépôt: 06.08.2024
(51) Int. Cl.: H10D 30/47, H10D 30/67, H10D 62/80, H10D 62/10, H10D 64/01, B82Y 10/00

(54) **DISPOSITIF MICROÉLECTRONIQUE COMPRENANT UNE GRILLE ENROBANTE ET PROCÉDÉ DE RÉALISATION D'UN TEL DISPOSITIF**
MIKROELEKTRONISCHE VORRICHTUNG MIT EINEM MANTELGITTER UND VERFAHREN ZUR HERSTELLUNG EINER SOLCHEN VORRICHTUNG
MICROELECTRONIC DEVICE COMPRISING A CONFORMAL GATE AND METHOD FOR MANUFACTURING SUCH A DEVICE

(30) Priorité: 11.08.2023 FR 2308691
(43) Date de publication de la demande: 12.02.2025
(73) Titulaire: Commissariat à l'Energie Atomique et aux Energies Alternatives, 75015 Paris (FR)
(72) Inventeur: BARRAUD, Sylvain, 38054 GRENOBLE Cedex 09 (FR)
(74) Mandataire: Hautier IP

(56) Documents cités:
- EP-A1- 4 191 668
- WO-A1-2008/023776
- US-A1- 2009 085 119
- US-A1- 2015 270 340
- US-A1- 2020 176 613
- US-A1- 2021 043 748
- US-A1- 2023 009 388

## Description

### DOMAINE TECHNIQUE

L'invention concerne le domaine des technologies de la microélectronique. Elle trouve pour application particulièrement avantageuse la fabrication de dispositifs avancés de type FET (« Field-Effect Transistor » en anglais, ou transistor à effet de champ) à grille enrobante et à canal à base de matériaux semi-conducteurs, notamment à base de matériaux bidimensionnels (2D) ou d'oxydes semiconducteurs.

### ETAT DE LA TECHNIQUE

L'augmentation constante des performances des transistors a d'abord été permise par la réduction des dimensions des transistors, pour une architecture MOSFET (« Metal-Oxide-Semiconductor Field-Effect Transistor » signifiant transistor à effet de champ Métal-Oxyde-Semiconducteur) classique basée sur le silicium.

Cette architecture classique a ensuite laissé place à d'autres types d'architectures mieux adaptées aux performances spécifiées dans les nœuds technologiques inférieurs à 12 nm. L'architecture dite « finFET » permet par exemple de répondre aux performances fixées par les nœuds technologiques 7 nm et 5 nm. Une telle architecture permet notamment d'ajuster facilement la tension de seuil des transistors pour privilégier les hautes performances ou la basse consommation énergétique, en fonction des applications visées.

Pour les prochains nœuds technologiques, notamment à partir de 3 nm et en deçà, d'autres architectures offrant un meilleur contrôle électrostatique sont nécessaires. Une architecture envisagée pour répondre aux problématiques de ces prochains nœuds technologiques comprend des transistors à grille enrobante dits transistors GAA (acronyme de Gate All Around). Ces transistors GAA comprennent typiquement des canaux très minces, sous forme de nanofils ou de nanofeuillets, empilés les uns sur les autres. Ce type d'architecture est cependant moins versatile que l'architecture « finFET ». La tension de seuil ne peut pas être ajustée facilement.

Le document « Multiple-Vt Solutions in Nanosheet Technology for High Performance and Low Power Applications, R. Bao et al., 2019 IEEE International Electron Devices Meeting (IEDM) » divulgue une solution permettant d'intégrer des transistors GAA nanofeuillets présentant une multitude de tensions de seuil. Le dispositif et le procédé divulgués par ce document sont basés sur l'introduction de dimensions de nanofeuillets variables au sein d'un même empilement, avec un bon contrôle dimensionnel de grille. Les différentes portions de grille enrobante présentent ainsi différentes épaisseurs de métal. Cela permet d'obtenir différentes tensions de seuil pour un même empilement. Quatre tensions de seuil différentes sont ainsi accessibles via cette architecture. Pour augmenter le nombre de tensions de seuil accessibles, différentes zones, réalisées avec des paramètres technologiques différents, restent nécessaires.

Le document WO 2008/023776 A1 décrit un transistor comprenant un empilement de couches semi-conductrices formant le canal. Une couche semi-conductrice présente sa face supérieure en contact avec une première électrode de grille via un film isolant de grille, et sa face inférieure en contact avec une deuxième électrode de grille, également au travers du film isolant. La première et la deuxième électrode de grille sont chacune reliées à des plots de contact distincts.

Le document US 2020/0176613 A1 divulgue un transistor à nanofils comportant deux électrodes de grille. Une première grille est en contact avec chacun des nanofils sur une face supérieure horizontale, une paroi verticale et une face inférieure horizontale, tandis qu'une seconde grille est en contact avec l'autre paroi verticale de chacun des nanofils.

Un enjeu majeur pour le développement de ces architectures de transistors GAA est la possibilité d'ajuster finement leur tension de seuil.

Un premier objectif de l'invention est de proposer une architecture de transistor GAA permettant un contrôle étendu de la tension de seuil. Un deuxième objectif de l'invention est de proposer un procédé de réalisation d'une telle architecture de transistor GAA. Un autre objectif de l'invention est de pallier au moins en partie les inconvénients des dispositifs et procédés connus.

### RESUME

Pour atteindre ces objectifs, selon un mode de réalisation on prévoit un dispositif microélectronique selon la revendication 1, le dispositif microélectronique comprenant au moins un transistor comprenant :
- au moins deux canaux empilés selon une direction principale z, chaque canal étant à base d'un matériau semiconducteur,
- une grille entourant au moins un des canaux,
- une source et un drain de part et d'autre des canaux, et des contacts de source et de drain connectés respectivement à la source et au drain,
- une couche diélectrique de grille séparant chaque canal de la grille,

La grille correspond à une première grille entourant partiellement au moins l'un des canaux.

Selon l'invention, l'au moins un transistor comprend une deuxième grille entourant partiellement le même canal que celui entouré par la première grille, les première et deuxième grilles étant isolées électriquement entre elles, de façon à ce qu'elles puissent être polarisées indépendamment l'une de l'autre.

Ainsi, le dispositif comprend deux grilles entourant les canaux du transistor, qui peuvent être polarisées de façon indépendante. Cela permet d'ajuster la tension de seuil du dispositif de façon continue, contrairement aux solutions connues qui permettent d'accéder uniquement à quelques tensions de seuil préalablement fixées par le design de l'architecture. Le dispositif selon l'invention présente avantageusement une gamme étendue de tensions de seuil pour une architecture GAA. Il peut être qualifié de dispositif à double grille, ou « dual gate ». La couche diélectrique de grille peut présenter des propriétés ferroélectriques, par exemple pour la réalisation de transistors mémoires de type FeFET (acronyme de « transistor à effet de champ ferroélectrique »).

Un autre aspect de l'invention concerne un procédé de fabrication de ce dispositif microélectronique. Le procédé selon la revendication 3 comprend les étapes suivantes :
- Fournir sur un substrat un empilement selon la direction principale z comprenant une pluralité de premières couches en un premier matériau alternées avec une pluralité de deuxièmes couches en un deuxième matériau alternées avec une pluralité de troisièmes couches en un troisième matériau, les premier, deuxième et troisième matériaux étant différents,
- Former un premier masque de gravure sur cet empilement,
- Former dans cet empilement des premières ouvertures définissant des premiers motifs à l'aplomb du premier masque de gravure,
- Former une grille sacrificielle de part et d'autre des premiers motifs, dans les premières ouvertures,
- Former un deuxième masque de gravure sur le premier masque de gravure et sur la grille sacrificielle, le deuxième masque de gravure étant transverse au premier masque de gravure,
- Former dans les premiers motifs des deuxièmes ouvertures définissant des deuxièmes motifs à l'aplomb du deuxième masque de gravure,
- Retirer partiellement, à partir des deuxièmes ouvertures, le troisième matériau des troisièmes couches sélectivement aux premier et deuxième matériaux des premières et deuxièmes couches, de sorte à former des troisièmes espaces dans les troisièmes couches,
- Remplir les troisièmes espaces par un troisième matériau diélectrique pour former des troisièmes espaceurs internes,
- Retirer partiellement, à partir des deuxièmes ouvertures, le premier matériau des premières couches sélectivement aux deuxième matériau des deuxièmes couches et aux troisièmes espaceurs internes, de sorte à former des premiers espaces dans les premières couches, de préférence à l'aplomb des troisièmes espaceurs internes,
- Remplir les premiers espaces par un premier matériau diélectrique pour former des premiers espaceurs internes,
- Retirer partiellement la grille sacrificielle de sorte à former des troisièmes ouvertures débouchant sur des parties restantes des troisièmes couches,
- Retirer totalement, à partir des troisièmes ouvertures, le troisième matériau des parties restantes des troisièmes couches, de sorte à former des troisièmes cavités,
- Former une première couche diélectrique dans les troisièmes cavités,
- Remplir par un premier matériau métallique les troisièmes cavités, de façon à former la première grille entourant partiellement les deuxièmes couches,
- Retirer totalement une partie restante de la grille sacrificielle de sorte à former des quatrièmes ouvertures débouchant sur des parties restantes des premières couches,
- Retirer totalement, à partir des quatrièmes ouvertures, le premier matériau des parties restantes des premières couches, de sorte à former des premières cavités,
- Former une deuxième couche diélectrique dans les premières cavités,
- Remplir par un deuxième matériau métallique les premières cavités, de façon à former la deuxième grille entourant partiellement les deuxièmes couches,
- Remplir les deuxièmes ouvertures par un matériau conducteur électrique de façon à former des contacts de source et de drain au contact des deuxièmes couches.

Un principe du procédé selon l'invention consiste à remplacer sélectivement certaines couches de l'empilement initial, ici les premières et troisièmes couches, pour former deux parties de grille typiquement inter-digitées, entourant des couches à base d'un matériau semiconducteur formant les canaux du transistor, ici les deuxièmes couches. Les avantages mentionnés ci-dessus pour le dispositif s'appliquent *mutatis mutandis* au procédé selon l'invention.

Selon une possibilité, les deuxièmes couches sont ultérieurement remplacées par un matériau semiconducteur afin de former les canaux du transistor. Dans ce cas, l'empilement initial ne comprend pas le matériau semiconducteur formant les canaux du transistor. Le dépôt ultérieur du matériau semiconducteur vise à mieux préserver le matériau semiconducteur. Selon une possibilité préférée, le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S) ou le sélénium (Se). Le procédé permet notamment d'introduire des couches de matériau 2D en fin de procédé, après structuration de l'empilement et notamment après la formation des espaceurs internes. Cela permet avantageusement de limiter le risque de dégradation du matériau 2D au cours du procédé. Le matériau 2D n'est pas exposé à toutes les étapes du procédé de fabrication. Le matériau 2D est ainsi préservé.

Une telle introduction tardive du matériau 2D au cours du procédé de fabrication permet en outre d'utiliser les technologies standard de la microélectronique pour la formation et la structuration de l'empilement. Il n'est pas nécessaire de modifier ou d'adapter les étapes technologiques standard de structuration aux contraintes d'utilisation du matériau 2D. Les coûts du procédé sont ainsi avantageusement limités. Le procédé peut être plus facilement implémenté dans des lignes de production existantes.

Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

Les figures nA (n=1...22 illustrent schématiquement selon des coupes transverses xz des étapes de fabrication d'un dispositif à canaux superposés, selon un premier mode de réalisation de la présente invention.
Les figures nB (n=1...22) illustrent schématiquement selon des coupes transverses yz indiquées sur les figures nA correspondantes, les mêmes étapes de fabrication du dispositif, selon un premier mode de réalisation de la présente invention.
Les figures nA (n=23...34) illustrent schématiquement selon des coupes transverses xz des étapes de fabrication d'un dispositif à canaux superposés, selon un deuxième mode de réalisation de la présente invention.
Les figures nB (n=23...34) illustrent schématiquement selon des coupes transverses yz indiquées sur les figures nA correspondantes, les mêmes étapes de fabrication du dispositif, selon un deuxième mode de réalisation de la présente invention.
Les figures nA (n=35, 36) illustrent schématiquement selon des coupes transverses xz des variantes d'un dispositif à canaux superposés, selon un autre mode de réalisation de la présente invention.
Les figures nB (n=35, 36) illustrent schématiquement selon des coupes transverses yz indiquées sur les figures nA correspondantes, les mêmes variantes du dispositif, selon un autre mode de réalisation de la présente invention.

Sur les figures en coupes transverses, des plans de coupe sont indiqués (A-A', B-B', ..., P-P'..., Z-Z', α- α', ..., ε-ε', ..., λ-λ') avec des références croisées aux plans de coupe des figures correspondantes. Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques de l'invention et des caractéristiques optionnelles qui peuvent éventuellement être utilisées en association ou alternativement :
Selon un exemple, chaque canal est entouré partiellement par la première grille et est entouré partiellement par la deuxième grille.

Selon l'invention, la première grille et la deuxième grille sont interdigitées.

Selon l'invention, chaque canal est intercalé entre un doigt de la première grille et un doigt de la deuxième grille.

Selon l'invention, la première grille recouvre deux côtés adjacents de l'un des canaux, et la deuxième grille recouvre deux autres côtés adjacents de ce canal.

Selon un exemple, les première et deuxième grilles présentent des formes complémentaires entourant complétement au moins un des canaux, en particulier entourant tous les côtés de ce canal.

Selon un exemple, le matériau semiconducteur est un dichalcogénure de métaux de transition MX2 avec M pris parmi le molybdène (Mo) ou le tungstène (W), et X pris parmi le soufre (S), le sélénium (Se) ou le tellure (Te).

Selon un autre exemple, le matériau semiconducteur est à base d'un oxyde semiconducteur, par exemple à base d'IGZO (Oxyde de zinc-indium-gallium), d'In2O3, d'IWO (Oxyde d'indium dopé au tungstène), d'ITO (Oxyde d'étain indium), d'IAZO (Oxyde de zinc indium-aluminium), d'InGaZnO, d'InGaO, d'InZnO ou d'un oxyde semiconducteur amorphe.

Selon un autre exemple, le matériau semiconducteur est à base de graphène, de nitrure de bore hexagonal « h-BN », de phosphorène.

Selon l'invention, l'empilement comprend une alternance d'une première couche avec une deuxième couche avec une troisième couche. De préférence, l'empilement initial ne comprend ni le matériau semiconducteur des canaux de transistors, ni les matériaux des différentes grilles ou parties de grille enrobante. Selon un exemple, les premières couches de l'empilement fourni sont uniquement au contact des deuxièmes couches et les troisièmes couches de l'empilement fourni sont uniquement au contact des deuxièmes couches.

Selon un exemple, les premiers et troisièmes espaceurs internes sont à base de nitrure de silicium. Les premiers espaceurs internes sont de préférence au contact des parties restantes des premières couches. Les troisièmes espaceurs internes sont de préférence au contact des parties restantes des troisièmes couches. Avant formation des premiers espaceurs internes, le retrait partiel du premier matériau des premières couches est configuré pour conserver des parties des premières couches entre les premiers espaces. Ces parties sont appelées parties restantes. Les parties restantes des premières couches sont ainsi situées entre les premiers espaces, selon une direction du plan xy. Avant formation des troisièmes espaceurs internes, le retrait partiel du troisième matériau des troisièmes couches est configuré pour conserver des parties des troisièmes couches entre les troisièmes espaces. Ces parties sont appelées parties restantes. Les parties restantes des troisièmes couches sont ainsi situées entre les troisièmes espaces, selon une direction du plan xy.

Selon un exemple, le procédé comprend en outre une séquence d'étapes configurée pour remplacer les deuxièmes couches, ladite séquence comprenant les étapes suivantes :
- Retirer totalement, à partir des deuxièmes ouvertures, le deuxième matériau des deuxièmes couches, par exemple sélectivement au premier matériau des premières couches, de sorte à former des deuxièmes espaces,
- Former de préférence une couche diélectrique dans les deuxièmes espaces,
- Déposer une couche à base d'un matériau semiconducteur dans les deuxièmes espaces, de sorte à former :
   ∘ des canaux à base du matériau semiconducteur à l'aplomb des première et deuxième grilles, sous les premier et deuxième masques de gravure, et
   ∘ des sources et drains à base du matériau semiconducteur à l'aplomb des premiers et troisièmes espaceurs internes.

Typiquement, pour des applications CMOS (transistors MOSFET) la couche diélectrique ne possède pas de propriétés ferroélectriques. Pour des applications mémoires (transistors FeFET) cette couche diélectrique possède des propriétés ferroélectriques.

Selon un exemple, la séquence d'étapes configurée pour remplacer les deuxièmes couches est effectuée après formation des premiers et troisièmes espaceurs internes et la formation des contacts de source et de drain est effectuée après ladite séquence d'étapes et avant le retrait partiel de la grille sacrificielle. Ce type de procédé, typiquement appelé « gate last », ou ici « dual gate last », prévoit la formation de la grille fonctionnelle en fin de procédé, en remplacement de la grille sacrificielle. Cela permet de préserver les caractéristiques dimensionnelles des première et deuxième grilles. Cela permet d'obtenir un meilleur contrôle de la tension de seuil des transistors MOSFET. Le budget thermique lié au dépôt de la couche à base du matériau semiconducteur n'impacte pas l'épaisseur équivalente d'oxyde de grille à l'interface avec les première et deuxième grilles. Les caractéristiques structurelles et électriques des deux grilles fonctionnelles sont mieux contrôlées.

Selon un exemple, la séquence d'étapes configurée pour remplacer les deuxièmes couches est effectuée après formation des première et deuxième grilles et avant formation des contacts de source et de drain. Ce type de procédé, typiquement appelé « gate first », ou ici « dual gate first », ou encore « channel last », prévoit la formation de la grille fonctionnelle en remplacement de la grille sacrificielle en début de procédé. Les canaux sont formés en fin de procédé. Cela permet de préserver les propriétés des canaux, notamment lorsque les canaux des transistors sont à base d'un matériau sensible à la température.

Selon un exemple, le procédé comprend en outre une formation d'espaceurs sur des flancs des premier et deuxième masques de gravure, lesdits espaceurs prenant appui sur une face supérieure des premiers motifs.

Selon un exemple, le dépôt de la couche à base du matériau semiconducteur se fait également sur des flancs du deuxième motif sensiblement parallèles à la direction principale z, en particulier sur des flancs des premiers espaceurs internes et sur des flancs des troisièmes espaceurs internes. Cela permet de faciliter la reprise des contacts de source et drain dans le dispositif.

Selon un exemple, le dépôt de la couche à base du matériau semiconducteur est configuré pour former des portions latérales de couche à base du matériau semiconducteur sur des flancs du deuxième motif sensiblement parallèles à la direction principale z, et des portions horizontales de couche à base du matériau semiconducteur dans les deuxièmes espaces, tel que les portions latérales soient plus épaisses que les portions horizontales. Des portions latérales plus épaisses permettent de diminuer la résistance de contact des contacts source et drain. Les canaux du transistor sont formés dans les portions horizontales.

Selon un exemple, le dépôt de la couche à base du matériau semiconducteur est configuré pour former des portions latérales de couche à base du matériau semiconducteur sur les espaceurs, sur les premiers espaceurs internes et sur les troisièmes espaceurs internes.

Selon un exemple, le procédé comprend une formation de contacts de source et drain dans les deuxièmes ouvertures.

Selon un exemple, le dépôt de la couche à base du matériau semiconducteur est effectué par dépôt chimique en phase vapeur ou par dépôt en couche atomique. Les dépôts chimiques en phase vapeur sont faciles à mettre en œuvre. Les dépôts en couche atomiques permettent de contrôler précisément l'épaisseur de la couche à base du matériau semiconducteur. Ces dépôts permettent d'obtenir une très bonne conformité pour la couche à base du matériau semiconducteur.

Selon un exemple, le matériau semiconducteur est choisi parmi les dichalcogénures de métaux de transition MX2 avec M pris parmi le molybdène (Mo) ou le tungstène (W), et X pris parmi le soufre (S), le sélénium (Se) ou le tellure (Te).

Selon un autre exemple, le matériau semiconducteur est choisi à base d'un oxyde semiconducteur, par exemple à base d'IGZO (Oxyde de zinc-indium-gallium), d'In2O3, d'IWO (Oxyde d'indium dopé au tungstène), d'ITO (Oxyde d'étain-indium), d'IAZO (Oxyde de zinc indium-aluminium), d'InGaZnO, d'InGaO, d'InZnO ou d'un oxyde semiconducteur amorphe.

Selon un exemple, le premier matériau est choisi en SiGe avec une concentration en germanium comprise entre 20%at et 25%at, le deuxième matériau est choisi en Si, et le troisième matériau est choisi en SiGe avec une concentration en germanium de l'ordre de 50%at. Ces matériaux peuvent être facilement épitaxiés par des procédés technologiques classiques de la microélectronique. Cela permet de bénéficier des voies technologiques existantes. Le coût du procédé est réduit. L'assignation des différents matériaux aux différentes couches peut être permutée.

Selon un exemple, la formation de la grille sacrificielle est effectuée de manière à ce que la grille sacrificielle s'étende sur toute une hauteur des premières ouvertures. Selon un exemple, les premières ouvertures s'étendent selon toute la hauteur de l'empilement des premières, deuxièmes et troisièmes couches. La grille sacrificielle s'étend sur toute la hauteur de l'empilement. La grille sacrificielle prend typiquement appui sur le substrat. Cela permet de donner un accès à toutes les couches de l'empilement via les troisièmes et quatrièmes ouvertures.

Selon un exemple, le dépôt de la couche à base du matériau semiconducteur est configuré pour que la couche à base du matériau semiconducteur remplisse totalement les deuxièmes espaces.

Selon un autre exemple, le dépôt de la couche à base du matériau semiconducteur est configuré pour que la couche à base du matériau semiconducteur remplisse partiellement les deuxièmes espaces. Selon un exemple, le procédé comprend en outre, après dépôt de la couche à base du matériau semiconducteur, un dépôt d'une couche diélectrique additionnelle configuré pour combler les deuxièmes espaces. Cela permet de former une couche à base du matériau semiconducteur de faible épaisseur, sans contrainte sur l'épaisseur des deuxièmes couches de l'empilement. La couche à base du matériau semiconducteur peut présenter une épaisseur inférieure à celle des deuxièmes couches de l'empilement initial.

Selon un exemple, le substrat est un substrat massif à base de silicium.

Selon un exemple, les premières ouvertures sont formées selon une direction longitudinale x et les deuxièmes ouvertures sont formées selon une direction transversale y perpendiculaire à la direction longitudinale x, lesdites premières et deuxièmes ouvertures s'étendant jusqu'au substrat.

Selon un exemple, le retrait du premier matériau des premières couches se fait sélectivement au deuxième matériau des deuxièmes couches avec une sélectivité S_{10:20} d'au moins 5:1, de préférence au moins 10:1. Selon un exemple, le retrait du troisième matériau des troisièmes couches se fait sélectivement au deuxième matériau des deuxièmes couches avec une sélectivité S_{30:20} d'au moins 5:1, de préférence au moins 10:1.

Selon un exemple, le retrait du deuxième matériau des deuxièmes couches se fait sélectivement au premier matériau des premières couches avec une sélectivité S_{20:10} d'au moins 5:1, de préférence au moins 10:1. Selon un exemple, le retrait du deuxième matériau des deuxièmes couches se fait sélectivement au troisième matériau des troisièmes couches avec une sélectivité S_{20:30} d'au moins 5:1, de préférence au moins 10:1.

Selon un exemple, le dépôt de la couche à base du matériau semiconducteur est configuré pour former des portions latérales de couche à base du matériau semiconducteur sur des flancs du deuxième motif dans les deuxièmes ouvertures. Selon un exemple, le procédé comprend en outre une formation de contacts de source et drain dans lesdites deuxièmes ouvertures et sur les portions latérales de couche à base du matériau semiconducteur, avant le début du retrait de la grille sacrificielle, ou après formation des première et deuxième grilles.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention, à condition qu'une telle combinaison comportait au moins les caractéristiques d'une des revendications indépendantes.

Les caractéristiques et les avantages d'un aspect de l'invention, par exemple le dispositif ou le procédé, peuvent être adaptés *mutatis mutandis* à l'autre aspect de l'invention.

L'invention porte d'une manière générale sur un dispositif microélectronique à transistors GAA et un procédé de fabrication. Un tel dispositif microélectronique peut présenter une architecture de type « GAA stacked nanosheet », c'est-à-dire à nanofeuilles empilées et grille partiellement ou totalement enrobante. Une architecture à nanofils empilés et grille partiellement ou totalement enrobante est également possible.

Les nanofils ou nanofeuilles comprennent typiquement chacun un canal de conduction d'un transistor. Ces canaux sont empilés selon une direction z. Cela signifie qu'ils occupent chacun un niveau d'altitude donnée selon la direction z. Un niveau peut être défini entre deux plans perpendiculaires à la direction z.

Dans la présente invention, chaque transistor comprend deux grilles. Ces deux grilles comprennent chacune des portions entourant les canaux du transistor. Ces portions peuvent typiquement être complémentaires de façon à entourer totalement ou quasi-totalement au moins l'un des canaux du transistor. Ces deux grilles peuvent être désignées comme « enrobantes » même si chaque grille n'enrobe pas totalement le ou les canaux du transistor. La combinaison des deux grilles peut s'apparenter à une grille entourant totalement le ou les canaux du transistor. Cette architecture relève donc à la fois des nomenclatures « Gate All Around » (grille totalement enrobante) et « Dual Gate » (double grille).

De manière avantageuse, le procédé selon l'invention peut être mis en œuvre pour la réalisation de transistors MOS GAA pour les nœuds technologiques 5 nm et sub-5 nm.

Un dispositif microélectronique comprenant des transistors GAA à canaux superposés peut être avantageusement intégré dans des systèmes logiques présentant des architectures 3D. Ces transistors peuvent notamment être associés à d'autres éléments structuraux ou fonctionnels de façon à concevoir des systèmes complexes.

Un aspect particulier de l'invention concerne la mise en œuvre de matériaux 2D pour réaliser les nanofils ou nanofeuilles du dispositif. Ces matériaux 2D présentent des propriétés de semiconducteur, notamment par la présence d'un gap électronique.

Les matériaux 2D correspondent typiquement à des composés présentant une structure lamellaire constituée de feuillets bidimensionnels, empilés selon l'axe cristallographique c. Les liaisons atomiques au sein de chaque feuillet sont fortes, de nature covalente. Les liaisons entre feuillets sont beaucoup plus faibles, de type Van der Waals. Ces feuillets bidimensionnels sont également appelés monocouches.

Dans le cadre de la présente invention, les monocouches sont de préférence des monocouches semiconductrices du type MX2 où M est du molybdène (Mo) ou du tungstène (W) et X du soufre (S) ou du sélénium (Se). Chaque « monocouche » est ici composée d'un plan de cations métalliques M inséré entre deux plans d'anions X. Une monocouche comprend donc ici typiquement trois plans atomiques : les atomes du métal de transition (Mo ou W) forment un plan pris en sandwich entre deux plans de chalcogènes (S, Se ou Te, par exemple). Chaque atome de métal de transition est relié à six atomes de chalcogène. Ces anions sont en coordination trigonale prismatique par rapport aux atomes de métal. Les monocouches de dichalcogénures de métaux de transition MX2 présentent un réseau atomique hexagonal.

Les monocouches de dichalcogénures de métaux de transition MX2 sont de préférence à base de disulfure de molybdène MoS2, MoSe2, MoTe2, WS2, WSe2.

Une possibilité alternative concerne la mise en œuvre d'oxydes semiconducteurs pour réaliser les nanofils ou nanofeuilles du dispositif, par exemple IWO, IGZO, ITO, InGaZnO, InGaO, InZnO, In2O3, IAZO. Une autre possibilité concerne la mise en œuvre de graphène, de nitrure de bore hexagonal « h-BN », de phosphorène (également connu sous le nom de « Black Phosphorous » BP), notamment sous forme de monocouche.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20. Dans la présente invention, la couche diélectrique peut présenter des propriétés ferroélectriques.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Les différents motifs formés au cours des étapes de fabrication présentent typiquement une structure destinée à évoluer lors des étapes du procédé. Ainsi, les motifs peuvent comprendre les couches sacrificielles de l'empilement initial, les couches à base de matériau 2D ou d'oxyde semiconducteur, les couches diélectriques, continues ou discontinues. Les différents motifs visent à former, en fin de procédé, des « motifs de transistors » comprenant chacun au moins un canal de conduction et deux grilles entourant ledit canal, une barrière diélectrique séparant les deux grilles entre elles et le canal, une source et un drain de part et d'autre du canal. L'assignation des premières et deuxièmes couches dans l'empilement initial peut être inversée.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente des exemples de mise en œuvre du procédé selon l'invention dans un contexte d'élaboration d'un dispositif 3D complexe. Le cadre de cette description n'est évidemment pas limitatif de l'invention.

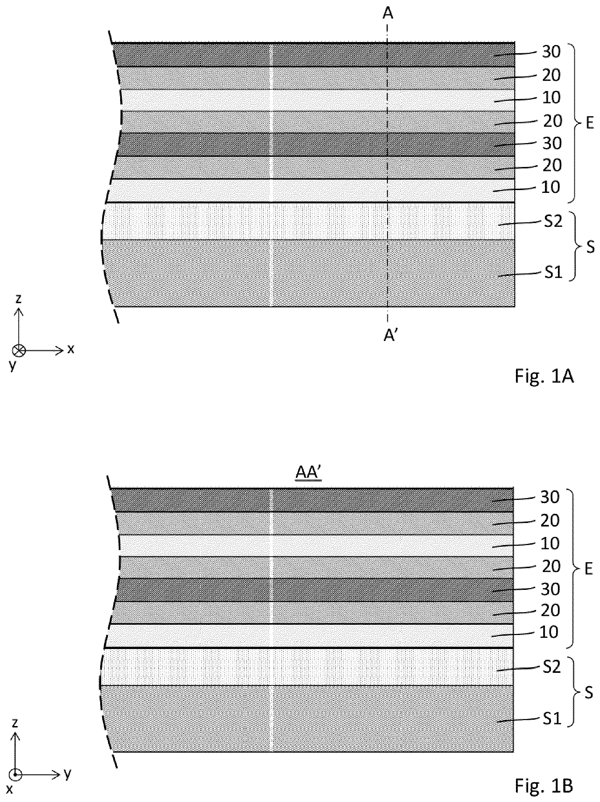

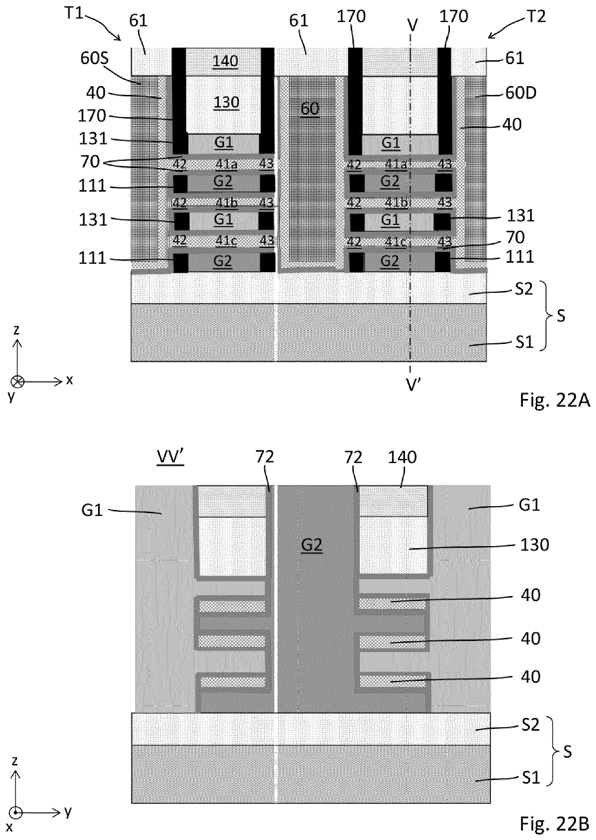

Les figures 1A, 1B à 22A, 22B illustrent schématiquement des étapes de fabrication d'un dispositif comprenant des transistors GAA selon un premier mode de réalisation. Les figures nA (n=1...22) correspondent à des premières coupes transverses illustrant chacune une étape différente du procédé de fabrication. Les figures nB (n=1...22) correspondent à des deuxièmes coupes transverses illustrant chacune la même étape que la figure nA correspondante. Ce premier mode de réalisation peut notamment être qualifié de « gate last » ou « dual gate last ». Les première et deuxième grilles sont ici formées en fin de procédé, après formation des canaux des transistors.

Comme illustré aux figures 1A, 1B, une première étape consiste à fournir ou réaliser un empilement E de couches semi-conductrices 10, 20, 30 sur un substrat S. Le substrat S peut être un substrat de type SOI (Silicon On Insulator), GeOI (Germanium On Insulator) ou SGOI (Silicon-Germanium On Insulator). Ces substrats connus comprennent, selon la terminologie courante pour l'homme du métier, une couche S1 de silicium épaisse dite « Si bulk », une couche S2 d'oxyde de silicium dite « BOX » (Burried Oxide) et une couche mince superficielle, respectivement à base de silicium, de germanium ou de silicium-germanium. Cette couche mince superficielle peut avantageusement correspondre à la première couche 10 de l'empilement E.

Alternativement, le substrat S peut être un substrat massif « Si bulk ».

L'empilement E comprend selon un exemple une alternance de premières couches 10 en silicium-germanium (SiGe) présentant une première composition en Ge, de deuxièmes couches 20 en silicium (Si), et de troisièmes couches 30 en SiGe présentant une deuxième composition en Ge.

Les concentrations de Ge dans l'alliage SiGe des premières et troisièmes couches 10, 30 sont choisies de façon à permettre une bonne sélectivité de gravure lors des étapes de gravure sélective entre les différentes couches. Selon un exemple, les premières couches 10 présentent une première composition en Ge comprise entre 20%at et 25%at. Selon un exemple, les troisièmes couches 30 présentent une deuxième composition en Ge de l'ordre de 50%at. Cet empilement E est avantageusement formé par épitaxie des couches de SiGe 10, 30 et de Si 20. Cette étape de formation de l'empilement E est peu coûteuse et bien connue de l'homme du métier. Les épaisseurs des couches Si et SiGe peuvent être typiquement de l'ordre de 10 nm, et plus généralement comprises entre 5 nm et 20 nm par exemple. De façon connue afin d'éviter la formation de défauts structuraux, les épaisseurs maximales permises pour les couches 10, 30 en SiGe dépendent notamment de la concentration en Ge choisie.

Dans l'exemple illustré aux figures 1A, 1B deux couches 10 de SiGe sont alternées avec trois couches 20 de Si épitaxiées et deux couches 30 de SiGe. Un super réseau Si/SiGe est ainsi obtenu. Le nombre de couches de Si et de SiGe peut naturellement être augmenté. Cela permet *in fine* d'augmenter le nombre de canaux empilés dans le dispositif final. L'enchainement des premières, deuxièmes et troisièmes couches 30 est de préférence choisi de façon à ce que chaque deuxième couche 20 soit intercalée entre une première couche 10 et une troisième couche 30. Dans le dispositif final, les premières couches sont destinées à être remplacées par des doigts d'une première grille et les troisièmes couches sont destinées à être remplacées par des doigts d'une deuxième grille, les premières et deuxièmes grilles étant interdigitées. Les deuxièmes couches sont destinées à former des canaux de transistor en partie entourés par la première grille et en partie entouré par la deuxième grille. L'enchainement des différentes couches 10, 20, 30 est donc choisi en fonction du design souhaité pour le dispositif final. Selon un exemple, les premières couches 10 sont uniquement au contact des deuxièmes couches 20 et les troisièmes couches 30 sont également uniquement au contact des deuxièmes couches 20.

D'une façon générale le premier matériau des premières couches 10, le deuxième matériau des deuxièmes couches 20 et le troisième matériau des troisièmes couches 30 sont choisis de façon à ce que les uns puissent être gravés sélectivement par rapport aux autres. Ainsi, d'autres couples de premier, deuxième et troisième matériaux sont possibles. En respectant cette condition de sélectivité à la gravure, les premier, deuxième et troisième matériaux peuvent être choisis parmi les matériaux diélectriques (oxydes et nitrures par exemple), les matériaux semiconducteurs, les matériaux métalliques. On veillera en particulier à ce que le troisième matériau puisse être gravé sélectivement vis-à-vis des premier et deuxième matériaux, et à ce que le premier matériau puisse être gravé sélectivement vis-à-vis du deuxième matériau.

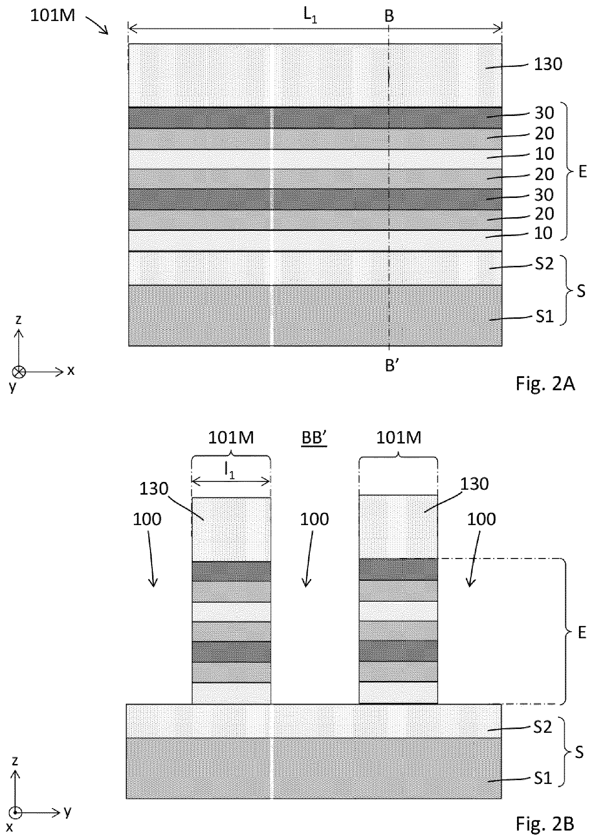

Comme illustré aux figures 2A, 2B, une étape classique de lithographie/gravure est réalisée afin de définir des premiers motifs 101M, et des premières ouvertures 100. La gravure est anisotrope et dirigée selon z. Elle est configurée pour graver l'empilement E, ici le super réseau Si/SiGe, sur toute sa hauteur, en s'arrêtant sur le substrat S, ici le BOX S2. Elle peut être effectuée par plasma en utilisant une chimie de gravure HBr/O2. Les premiers motifs 101M peuvent présenter une longueur L₁ selon x comprise entre 10 nm et 500 nm. Ils présentent de préférence une largeur l₁ selon y comprise entre 10 nm et 120 nm, par exemple de l'ordre de 40 nm. Cette première structuration de l'empilement E sous forme d'ailettes ou « fins » selon la terminologie anglo-saxonne courante, permet de définir une pluralité de nanofils ou de nanosheets superposés. Les motifs de « fin » 101M sont typiquement surmontés par un masque de gravure ou masque dur 130 mis en œuvre lors de cette première structuration de l'empilement E.

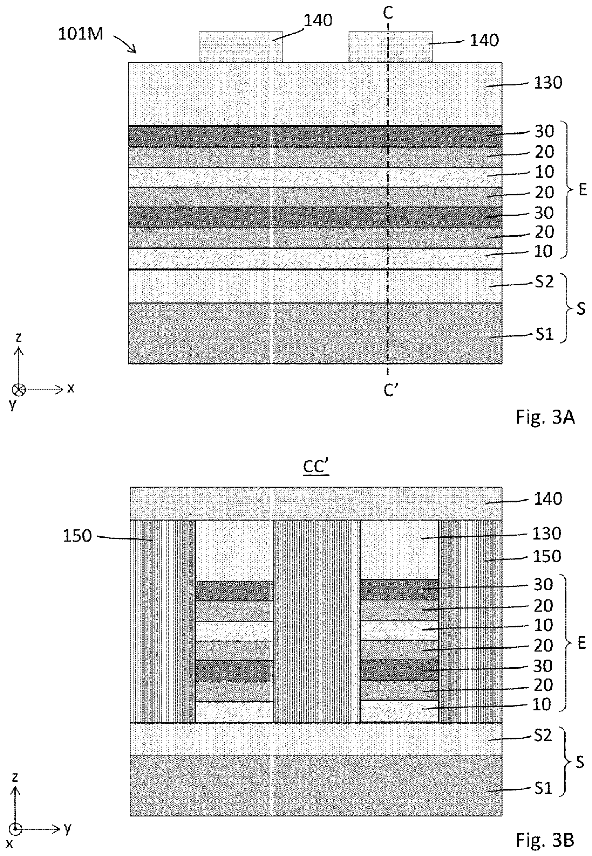

Comme illustré aux figures 3A, 3B, des grilles sacrificielles 150 sont ensuite formées entre les motifs de « fin » 101M. La formation de ces grilles sacrificielles 150 se fait typiquement par dépôt puis polissage mécano-chimique CMP avec arrêt sur le masque dur 130. Les grilles sacrificielles 150 comprennent typiquement plusieurs portions indépendantes situées entre les motifs de « fin » 101M. Cela facilite une ouverture localisée des différentes portions des grilles sacrificielles par la suite. Les grilles sacrificielles 150 prennent typiquement appui sur le substrat S. Un masque de gravure ou masque dur 140 est formé transversalement aux motifs de « fin » 101M. Ce masque dur 140 participe ensuite à une deuxième structuration de l'empilement E, ainsi qu'à une structuration des grilles sacrificielles 150, comme illustré dans les figures suivantes. Les grilles sacrificielles 150 sont par exemple à base de silicium polycristallin. Une fine couche d'oxyde SiO₂, d'épaisseur 7 nm par exemple, est de préférence déposée préalablement à la formation des grilles sacrificielles 150. Cette fine couche d'oxyde SiO₂ (non illustrée sur les figures) est ainsi intercalée entre les grilles sacrificielles 150 et les motifs de « fin » 101M. Cette fine couche d'oxyde SiO₂ peut former une couche d'arrêt pour la gravure ultérieure des grilles sacrificielles 150.

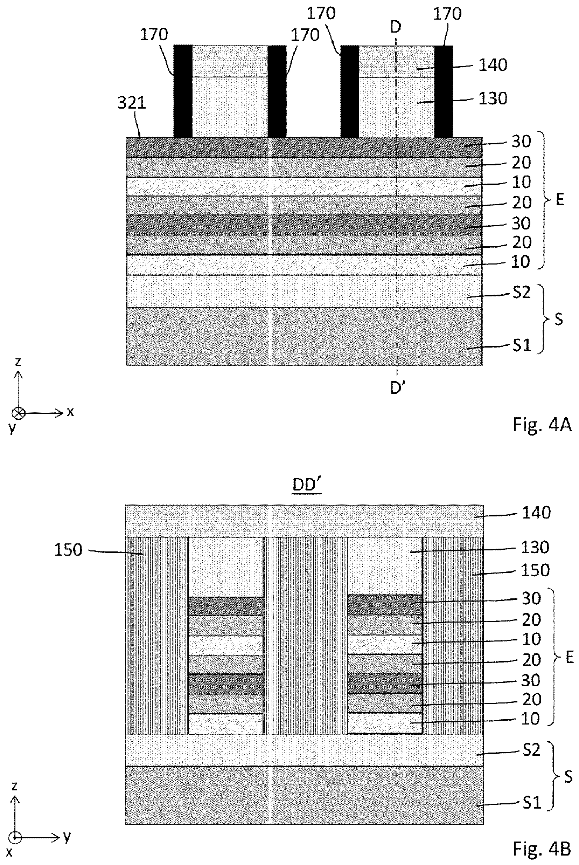

Comme illustré aux figures 4A, 4B, le masque dur 130 est d'abord gravé de façon à exposer la face supérieure 321 de l'empilement E. Les portions de masque dur 130 situées sous le masque dur 140 sont conservées, ainsi que le masque dur 140. Des espaceurs 170 sont ensuite formés sur les flancs orientés selon yz des masques durs 130, 140. En général, en projection selon z, ces espaceurs forment une bague continue autour des masques durs 130, 140, avec un contour fermé. En coupe transverse cependant, selon le plan xz illustré à la figure 4A, l'espaceur 170 présente deux parties en vis-à-vis sur chacun des flancs des masques durs 130, 140. Ces deux parties sont généralement désignées comme étant les espaceurs 170, même si celles-ci peuvent être considérées comme appartenant à un seul et même espaceur. Les espaceurs 170 s'étendent typiquement jusqu'à la face supérieure 321 de l'empilement E. Les espaceurs 170 sont typiquement à base de nitrure de silicium SiN ou d'un matériau diélectrique à faible constante diélectrique, par exemple à base de SiCO.

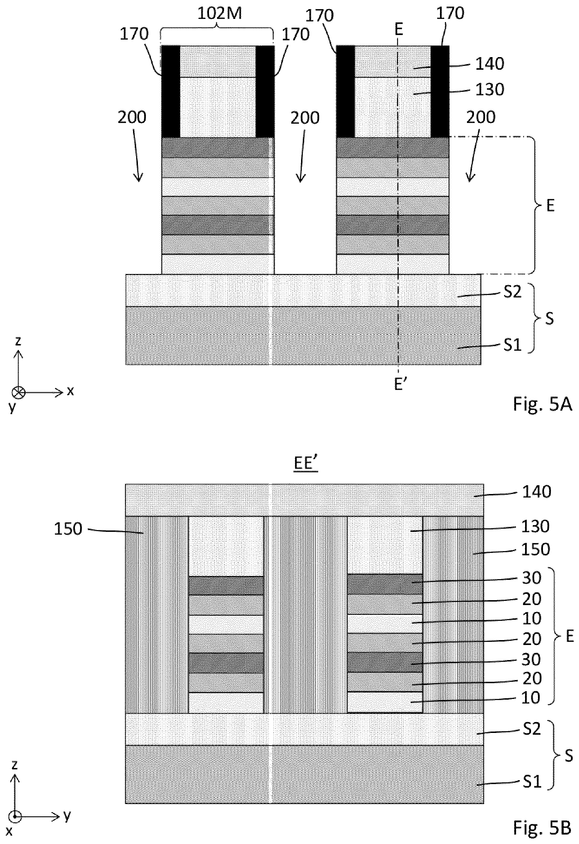

Comme illustré aux figures 5A, 5B, après formation des espaceurs 170 par dépôt/gravure, la gravure anisotrope selon z est prolongée afin de définir des deuxièmes motifs 102M, et des deuxièmes ouvertures 200. La gravure est configurée pour graver l'empilement E sur toute sa hauteur, en s'arrêtant sur le substrat S. Elle peut être effectuée par plasma en utilisant une chimie de gravure HBr/O2. Une deuxième structuration de l'empilement E est ainsi effectuée.

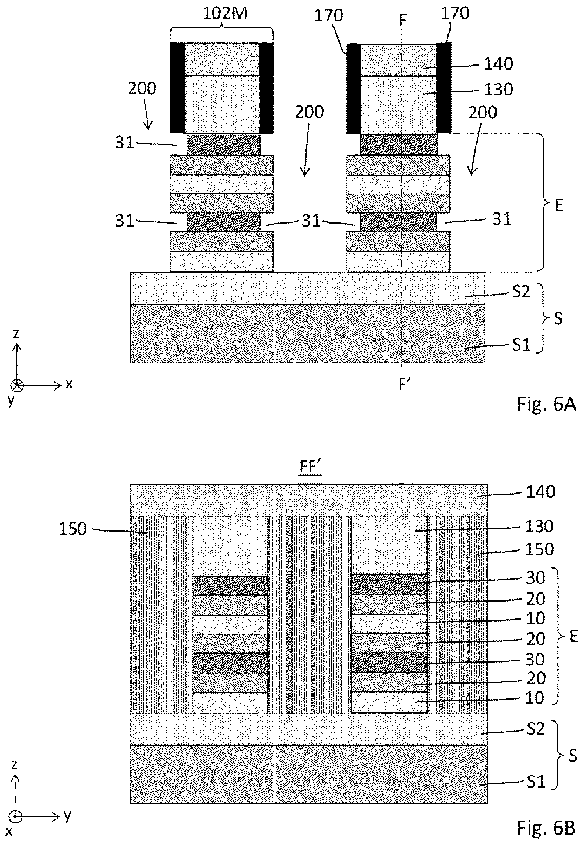

Comme illustré aux figures 6A, 6B, après formation des deuxièmes ouvertures 200, les troisièmes couches 30 sont partiellement gravées sélectivement aux deuxièmes couches 20, aux premières couches 10, au substrat S et aux espaceurs 170. La gravure du troisième matériau des troisièmes couches 30 présente typiquement une sélectivité S_{30:20} par rapport au deuxième matériau des deuxièmes couches 20, d'au moins 5:1, de préférence au moins 10:1. La gravure du troisième matériau des troisièmes couches 30 présente typiquement une sélectivité S_{30:10} par rapport au premier matériau des premières couches 10, d'au moins 5:1, de préférence au moins 10:1. Cette gravure partielle vise à former des troisièmes espaces 31 à l'aplomb des espaceurs 170. Cette gravure partielle est typiquement arrêtée au temps. Elle présente un caractère isotrope et peut être effectuée par voie humide ou par voie sèche, à partir des deuxièmes ouvertures 200. A l'issue de cette gravure partielle, des parties centrales des troisièmes couches 30 sont conservées sous les masques durs 130, 140.

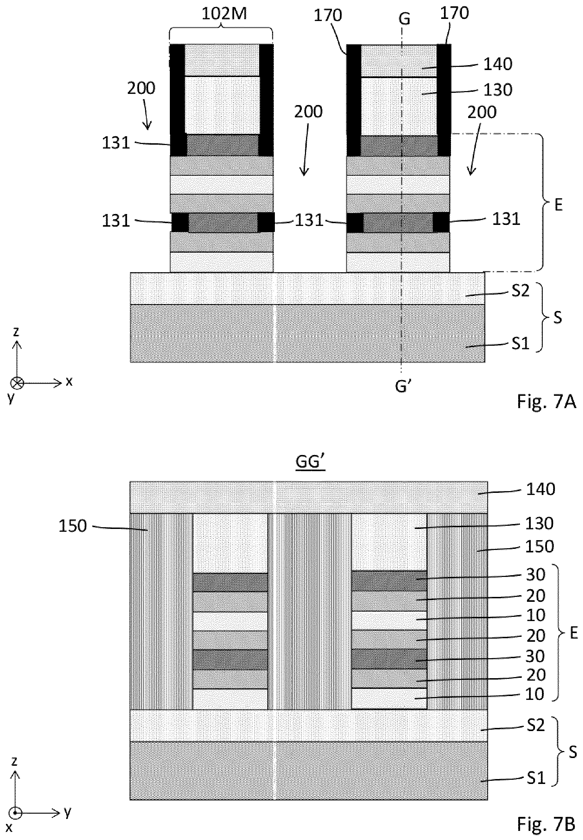

Comme illustré aux figures 7A, 7B, les troisièmes espaces 31 sont ensuite remplis par un matériau diélectrique, par exemple par du nitrure de silicium ou par un diélectrique à faible permittivité, pour former des troisièmes espaceurs internes 131. Ces espaceurs « internes » 131 sont intégrés dans l'empilement E, de préférence à l'aplomb des espaceurs 170. Ils sont au contact des parties centrales des troisièmes couches 30. La formation des troisièmes espaceurs internes 131 se fait typiquement à partir des deuxièmes ouvertures 200.

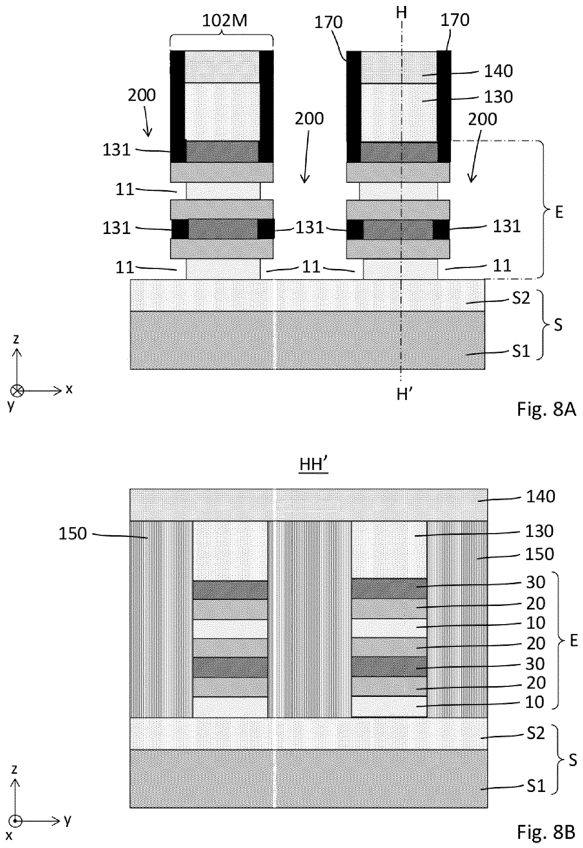

Comme illustré aux figures 8A, 8B, les premières couches 10 sont partiellement gravées sélectivement aux deuxièmes couches 20, au substrat S, aux espaceurs 170 et aux troisièmes espaceurs internes 131. La gravure du premier matériau des premières couches 10 présente typiquement une sélectivité S_{10:20} par rapport au deuxième matériau des deuxièmes couches 20, d'au moins 5:1, de préférence au moins 10:1. Cette gravure partielle vise à former des premiers espaces 11 à l'aplomb des espaceurs 170 et des troisièmes espaceurs internes 131. Cette gravure partielle est typiquement arrêtée au temps. Elle présente un caractère isotrope et peut être effectuée par voie humide ou par voie sèche, à partir des deuxièmes ouvertures 200. A l'issue de cette gravure partielle, des parties centrales des premières couches 10 sont conservées sous les masques durs 130, 140.

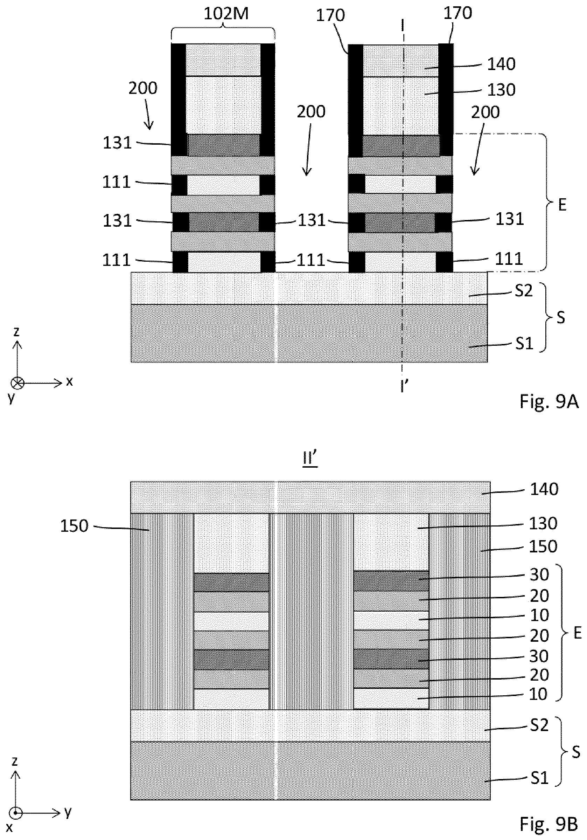

Comme illustré aux figures 9A, 9B, les premiers espaces 11 sont ensuite remplis par un matériau diélectrique, par exemple par du nitrure de silicium ou par un diélectrique à faible permittivité, pour former des premiers espaceurs internes 111. Ces espaceurs « internes » 111 sont intégrés dans l'empilement E, de préférence à l'aplomb des espaceurs 170 et des troisièmes espaceurs internes 131. Ils sont au contact des parties centrales des premières couches 10. La formation des premiers espaceurs internes 111 se fait typiquement à partir des deuxièmes ouvertures 200.

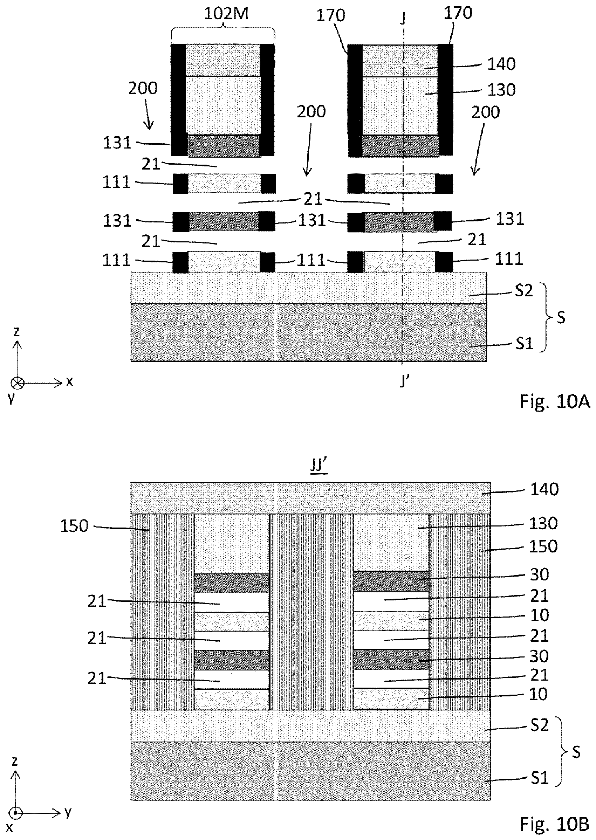

Comme illustré aux figures 10A, 10B, les deuxièmes couches 20 sont ensuite gravées sélectivement aux parties centrales des premières couches 10 et des troisièmes couches 30, et aux espaceurs internes 111, 131. La gravure du deuxième matériau des deuxièmes couches 20 présente typiquement une sélectivité S_{20:10} par rapport au premier matériau des premières couches 10, d'au moins 5:1, de préférence au moins 10:1. La gravure du deuxième matériau des deuxièmes couches 20 présente typiquement une sélectivité S_{20:30} par rapport au troisième matériau des troisièmes couches 30, d'au moins 5:1, de préférence au moins 10:1. Cette gravure totale peut être arrêtée au temps, possiblement après un temps de surgravure visant à garantir le retrait total du deuxième matériau des deuxièmes couches 20. Cette gravure totale présente un caractère isotrope et peut être effectuée par voie humide ou par voie sèche, à partir des deuxièmes ouvertures 200. A l'issue de cette gravure, les deuxièmes couches 20 sont retirées totalement pour former des deuxièmes espaces 21. Les parties centrales des premières couches 10 et les parties centrales des troisièmes couches 30 sont maintenues par les grilles sacrificielles 150, comme illustré à la figure 10B.

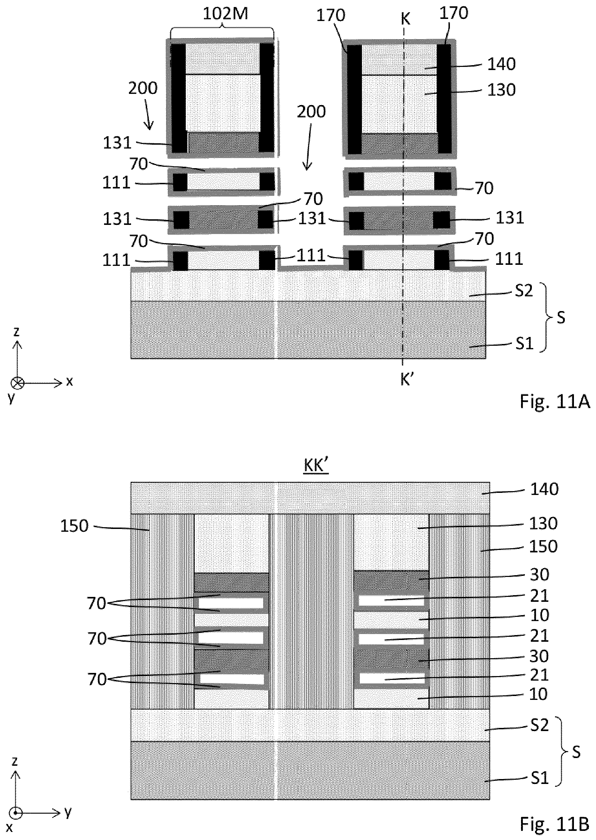

Comme illustré aux figures 11A, 11B, une couche diélectrique 70 est ensuite déposée dans les deuxièmes espaces 21. Cette couche diélectrique 70 est typiquement à base d'un matériau à forte permittivité, par exemple à base de HfO2. La couche diélectrique 70 est destinée à former la couche diélectrique de grille entre les canaux des transistors GAA et leurs grilles enrobantes. Elle peut être formée par dépôt chimique en phase vapeur CVD (acronyme de « Chemical Vapor Deposition »), par dépôt chimique en phase vapeur à précurseurs organométalliques MOCVD (acronyme de « Metal Organic Chemical Vapor Deposition ») ou par dépôt en couche atomique ALD (acronyme de « Atomic Layer Deposition »). Elle recouvre ainsi au moins les parties centrales des premières couches 10 et les parties centrales des troisièmes couches 30, et de préférence les espaceurs internes 111, 131, et les espaceurs 170. La couche diélectrique 70 présente typiquement une épaisseur comprise entre 1 nm et 5 nm. Selon un exemple alternatif, cette couche 70 peut être à base d'un matériau ferroélectrique tel que HfZrO2, HZO, HfO2 dopé Si par exemple. Une telle couche ferroélectrique 70 peut être avantageusement employée pour la réalisation de transistors mémoires de type FeFET (acronyme de « transistor à effet de champ ferroélectrique »). Cette couche diélectrique 70 forme typiquement un motif de maille vénitienne dans chaque motif 102M.

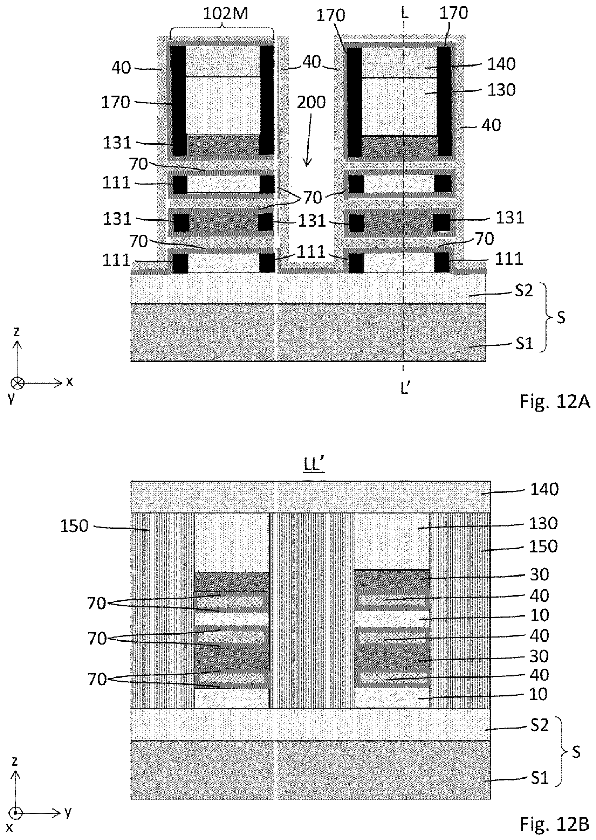

Comme illustré aux figures 12A, 12B, une couche 40 à base d'un matériau semiconducteur est ensuite déposée sur la couche diélectrique 70 de grille dans les deuxièmes espaces 21. Le dépôt du matériau semiconducteur est ici configuré pour que la couche 40 remplisse totalement les deuxièmes espaces 21. Les portions de la couche 40 situées dans les deuxièmes espaces 21 présentent ainsi une épaisseur parfaitement contrôlée, proche de l'épaisseur des deuxièmes couches initiales. Cette couche 40 est destinée à former les canaux 41 des transistors GAA à l'aplomb des parties centrales des premières couches 10 et des parties centrales des troisièmes couches 30. Cette couche 40 est également destinée à former les sources 42 et les drains 43 des transistors GAA à l'aplomb des espaceurs 170 et des espaceurs internes 111, 131.

La couche 40 est également typiquement déposée en dehors des deuxièmes espaces 21, sur les flancs des espaceurs 170 et des espaceurs internes 111, 131. Cela permet d'améliorer la reprise de contact avec les sources 42 et les drains 43 des transistors GAA. La couche 40 présente ainsi des portions horizontales dans les deuxièmes espaces 21, notamment entre les parties restantes des premières couches et des troisièmes couches, et des portions verticales sur les flancs des espaceurs 170 et des espaceurs internes 111, 131. Selon une possibilité, l'épaisseur des portions verticales de la couche 40 est plus importante que l'épaisseur des portions horizontales de la couche 40. Cela permet de réduire la résistance de contact pour les sources 42 et les drains 43 des transistors GAA. Les sources 42 et les drains 43 des transistors GAA peuvent comprendre les portions horizontales à l'aplomb des espaceurs 170 et des espaceurs internes 111, 131, et au moins en partie les portions verticales sur les flancs des espaceurs 170 et des espaceurs internes 111, 131.

Le matériau semiconducteur de la couche 40 est avantageusement un matériau bidimensionnel pris parmi les dichalcogénures de métaux de transition MX2 avec M le molybdène (Mo) ou le tungstène (W), et X le soufre (S), le sélénium (Se) ou le tellure (Te). Un tel matériau 2D peut être avantageusement déposé sous forme de couche mince comprenant 1 à 10 couches atomiques, de préférence 1 à 5 couches atomiques. Le dépôt de ce matériau 2D peut se faire par CVD, MOCVD ou ALD. Selon une autre possibilité, le matériau semiconducteur de la couche 40 est un oxyde semiconducteur tel que l'ITO (acronyme de « Indium Tin Oxide »), l'IGZO (acronyme de « Indium Gallium Zinc Oxide »), l'IWO (signifiant « tungsten doped indium oxide »), l'oxyde d'indium In2O3. Selon une autre possibilité, le matériau semiconducteur de la couche 40 est un graphène, un nitrure de bore hexagonal « h-BN », un phosphorène (également connu sous le nom de « Black Phosphorous » BP), sous forme de monocouche ou de couche mince comprenant 1 à 10 couches atomiques, de préférence 1 à 5 couches atomiques.

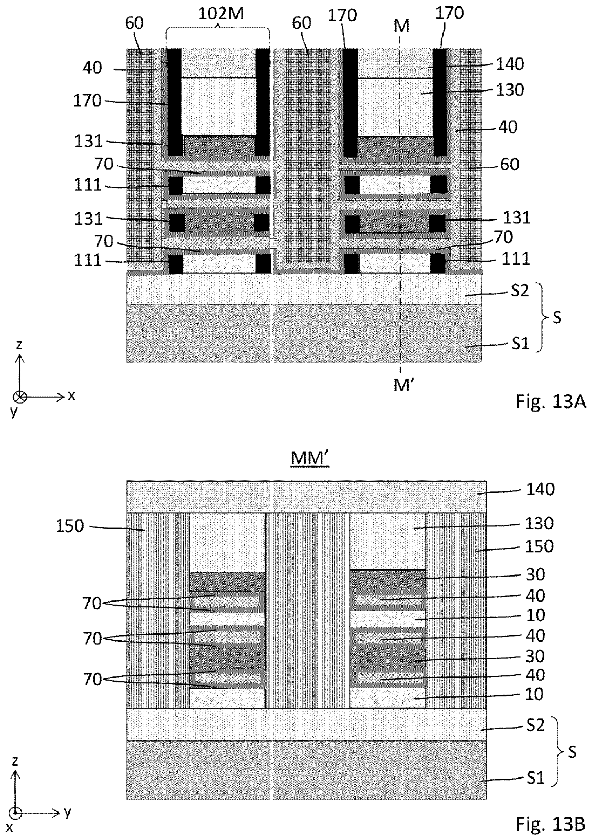

Comme illustré aux figures 13A, 13B, les deuxièmes ouvertures peuvent ensuite être remplies par une ou plusieurs couches métalliques 60, par exemple à base de Ti, TiN, W, ou par d'autres métaux permettant d'assurer une faible résistance de contact tels que Bi, Ni, Au, Sb, etc., afin de former les contacts de source et drain. Un polissage mécano-chimique CMP est typiquement effectué afin de retirer l'excès de métal déposé sur les motifs 102M. Les masques durs 140 sont ainsi exposés.

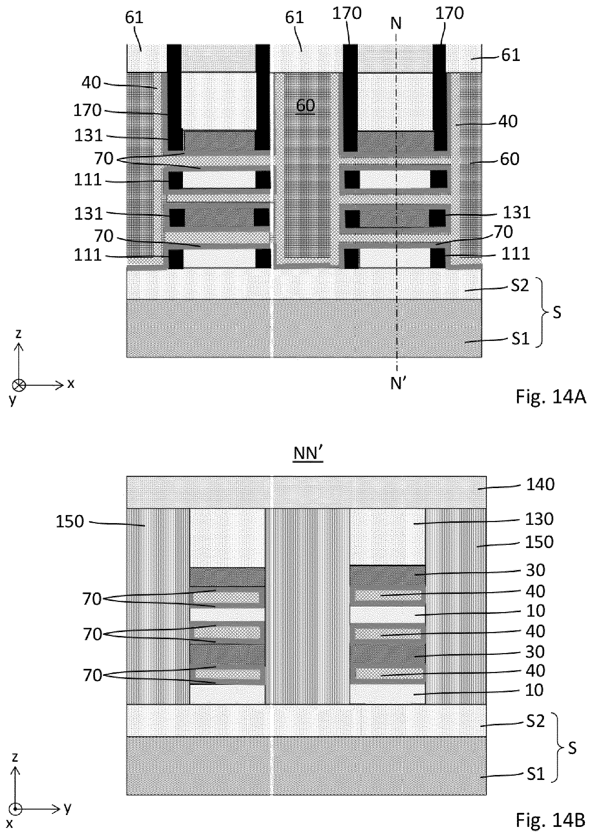

Comme illustré aux figures 14A, 14B, des bouchons de protection 61, par exemple à base de SiO2, sont de préférence formés aux extrémités supérieures des contacts 60. Cela permet de protéger les couches métalliques sous-jacentes lors des étapes suivantes de remplacement des différentes portions de grille sacrificielle.

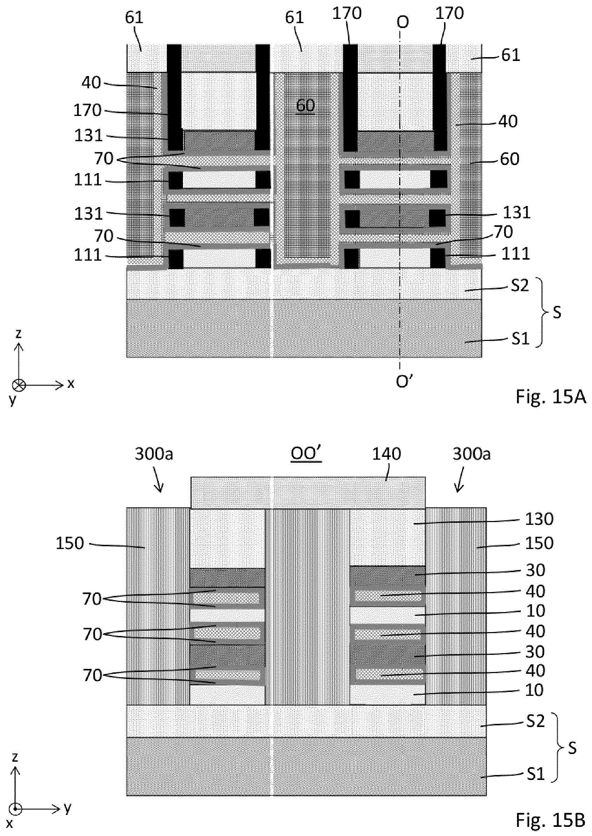

Comme illustré aux figures 15A, 15B, le masque dur 140 est en partie ouvert pour accéder à certaines portions de la grille sacrificielle 150 via les ouvertures 300a. Les différentes portions de la grille sacrificielle 150 sont séparées par les motifs de « fin ». En particulier, les ouvertures 300a sont configurées pour accéder à une portion sur deux de la grille sacrificielle 150, de façon alternée.

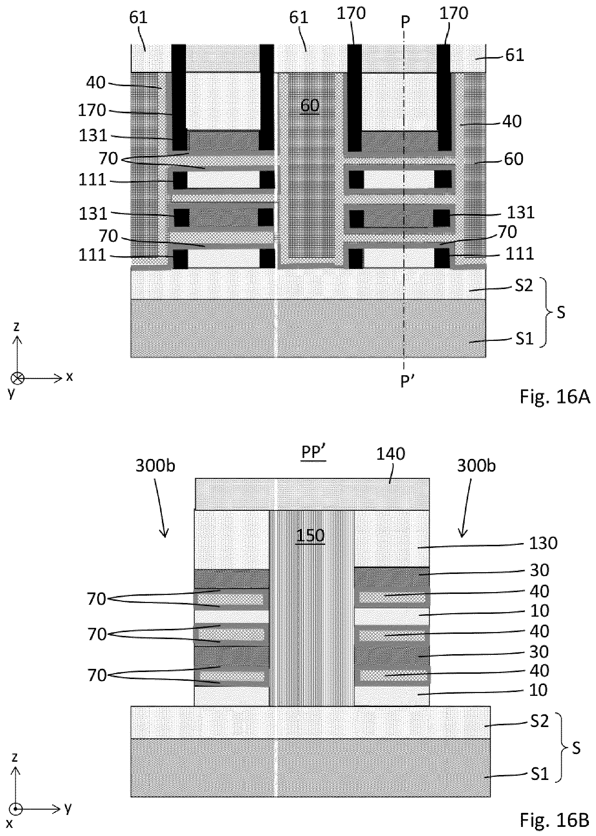

Comme illustré aux figures 16A, 16B, les portions exposées de la grille sacrificielle 150 sont ensuite retirées pour former les troisièmes ouvertures 300b. Ce retrait peut être effectué par gravure humide avec arrêt sur la fine couche d'arrêt à base de SiO2 de la grille sacrificielle 150. Cette gravure humide présente typiquement une sélectivité élevée vis-à-vis de la couche d'arrêt. Cette gravure humide peut être à base d'une solution de sels d'ammoniaque TMAH (Hydroxyde de tétraméthylammonium) ou TEAH (Hydroxyde de tétraéthylammonium). La couche d'arrêt à base de SiO2 est ensuite typiquement gravée par voie humide pour exposer un premier flanc des motifs de « fin ». Les troisièmes ouvertures 300b débouchent sur les parties centrales des troisièmes couches 30 (figure 16B).

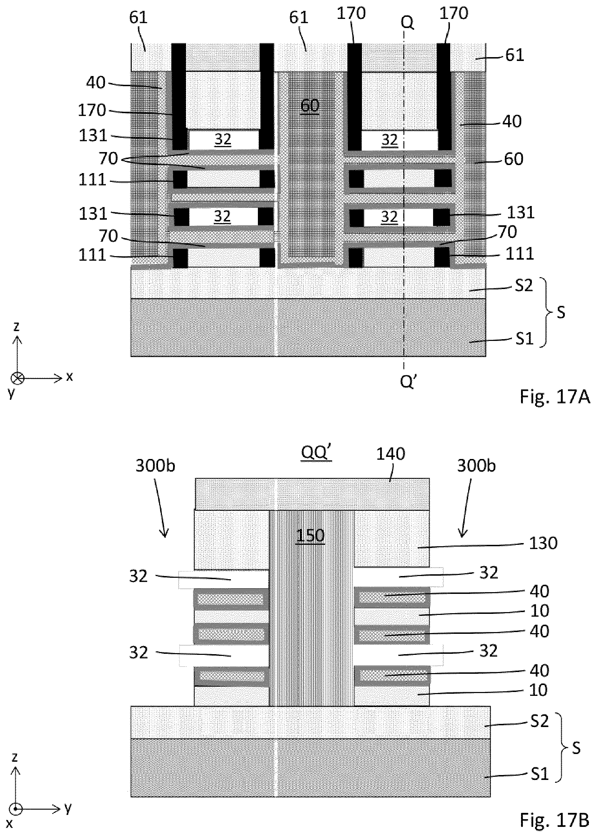

Comme illustré aux figures 17A, 17B, les parties centrales des troisièmes couches 30 sont ensuite totalement retirées par gravure sélective vis-à-vis de la couche diélectrique 70 et des parties centrales des premières couches 10, à partir des troisièmes ouvertures 300b. Cette gravure vise à former des troisièmes cavités 32 à la place des parties centrales des troisièmes couches 30. Cette gravure présente un caractère isotrope et peut être effectuée par voie humide ou par voie sèche, à partir des troisièmes ouvertures 300b.

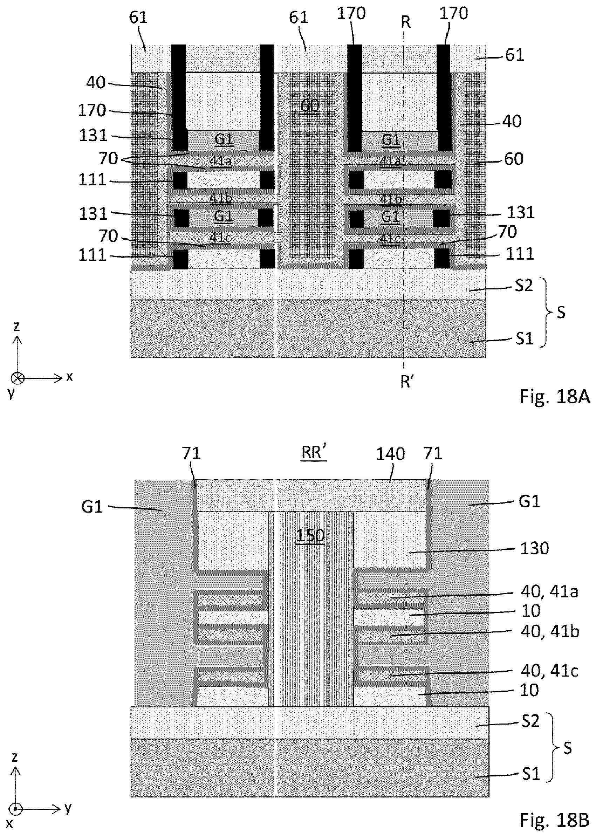

Comme illustré aux figures 18A, 18B, les troisièmes ouvertures 300b et les troisièmes cavités 32 sont ensuite remplies par une ou plusieurs couches métalliques, par exemple à base de TiN, W, afin de former une première grille G1 des transistors GAA. Avant dépôt des couches métalliques, une couche diélectrique 71 à base d'un matériau à forte permittivité, par exemple à base de HfO2, est préalablement déposée de façon à tapisser les troisièmes ouvertures 300b et les troisièmes cavités 32. Cela permet d'augmenter l'épaisseur de la couche diélectrique de grille entre les canaux 41a, 41b, 41c des transistors GAA et la première grille G1. Cela permet également d'isoler la première grille G1 vis-à-vis des parties centrales des premières couches 10, destinées à former une deuxième partie de grille. Un polissage mécano-chimique CMP est typiquement effectué afin de retirer l'excès de métal déposé sur les motifs 102M.

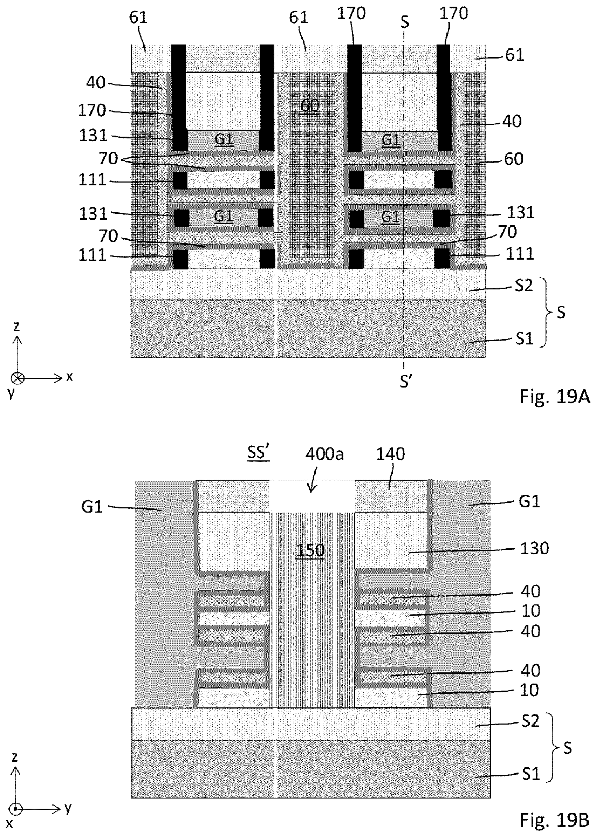

Comme illustré aux figures 19A, 19B, le masque dur 140 est de nouveau en partie ouvert pour accéder aux portions restantes de la grille sacrificielle 150, via des ouvertures 400a.

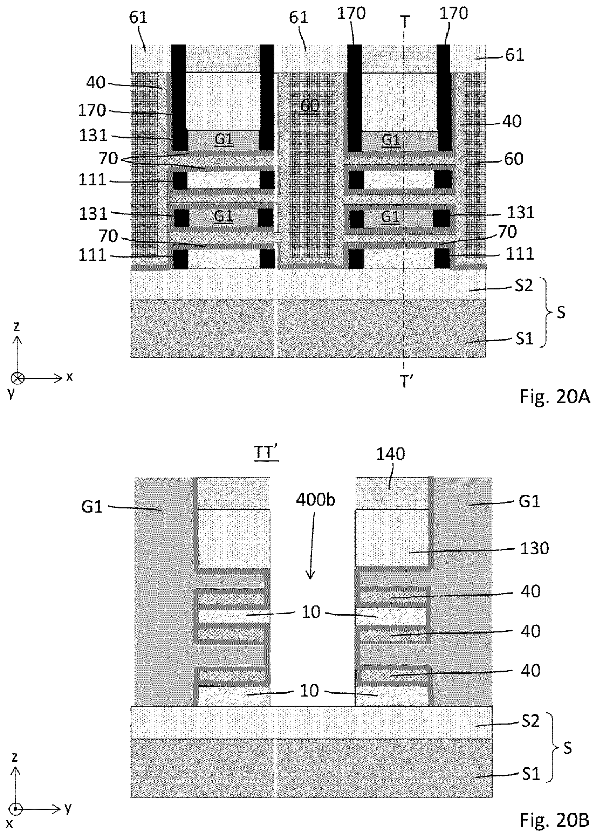

Comme illustré aux figures 20A, 20B, les portions restantes de la grille sacrificielle 150 sont ensuite retirées pour former les quatrièmes ouvertures 400b. Ce retrait peut être effectué comme précédemment, par gravure humide à base de TMAH ou de TEAH, avec arrêt sur la fine couche d'arrêt à base de SiO2 de la grille sacrificielle 150. La couche d'arrêt à base de SiO2 est ensuite typiquement gravée par voie humide pour exposer un deuxième flanc des motifs de « fin ». Les quatrièmes ouvertures 400b débouchent sur les parties centrales des premières couches 10 (figure 20B).

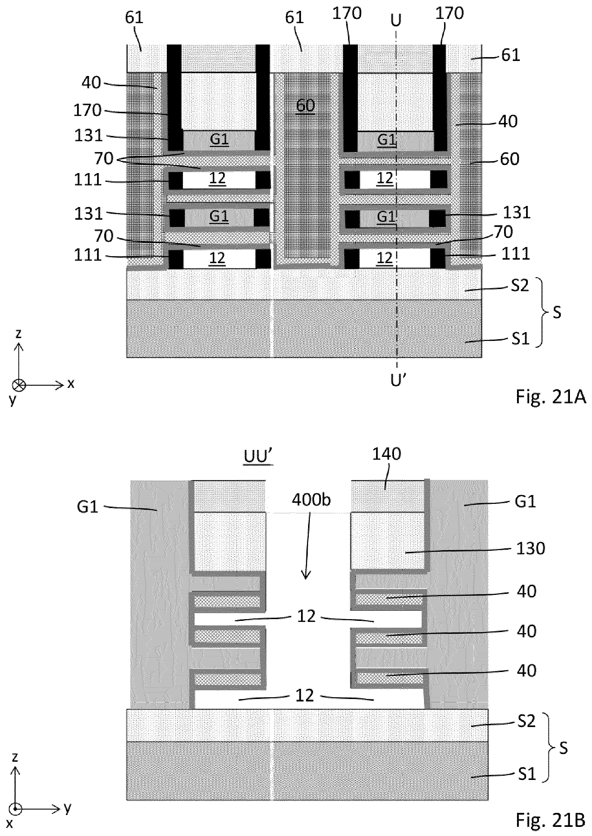

Comme illustré aux figures 21A, 21B, les parties centrales des premières couches 10 sont ensuite totalement retirées par gravure sélective vis-à-vis des couches diélectriques 70, 71, à partir des quatrièmes ouvertures 400b. Cette gravure vise à former des premières cavités 12 à la place des parties centrales des premières couches 10. Cette gravure présente un caractère isotrope et peut être effectuée par voie humide ou par voie sèche, à partir des quatrièmes ouvertures 400b.

Comme illustré aux figures 22A, 22B, les quatrièmes ouvertures 400b et les premières cavités 12 sont ensuite remplies par une ou plusieurs couches métalliques, par exemple à base de TiN, W, afin de former une deuxième grille G2 des transistors GAA. Avant dépôt des couches métalliques, une couche diélectrique 72 à base d'un matériau à forte permittivité, par exemple à base de HfO2, est préalablement déposée de façon à tapisser les quatrièmes ouvertures 400b et les premières cavités 12. Cela permet d'augmenter l'épaisseur de la couche diélectrique de grille entre les canaux 41a, 41b, 41c des transistors GAA et la deuxième grille G2. Cela permet également d'isoler la deuxième grille G2 vis-à-vis de la première grille G1. Un polissage mécano-chimique CMP est typiquement effectué afin de retirer l'excès de métal déposé sur les motifs 102M.

Un dispositif microélectronique comprenant deux transistors T1, T2 comprenant chacun trois canaux 41a, 41b, 41c empilés selon z, et deux grilles enrobantes G1, G2 interdigitées, est ainsi avantageusement obtenu. Les canaux 41a, 41b, 41c, les sources 42 et les drains 43 sont de préférence à base d'un matériau bidimensionnel. Des contacts de source et drain 60S, 60, 60D viennent connecter électriquement ces transistors GAA T1, T2.

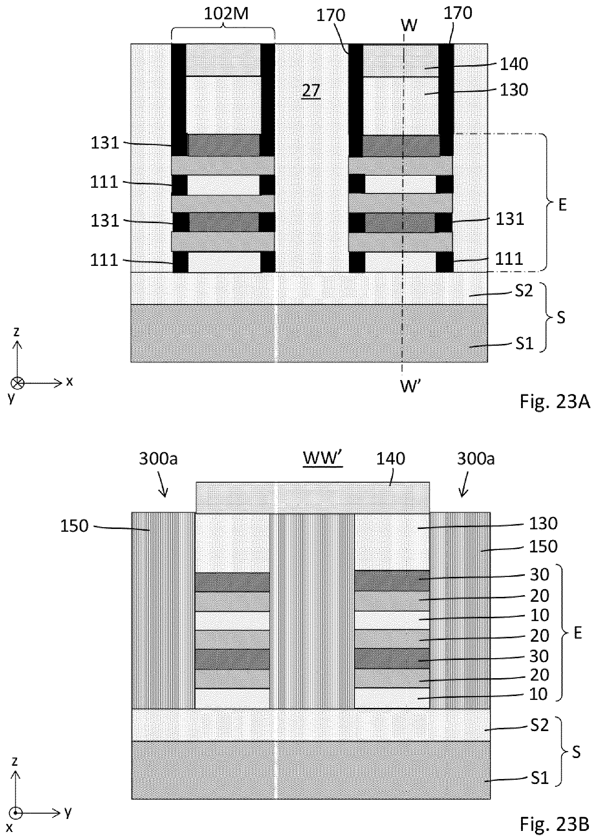

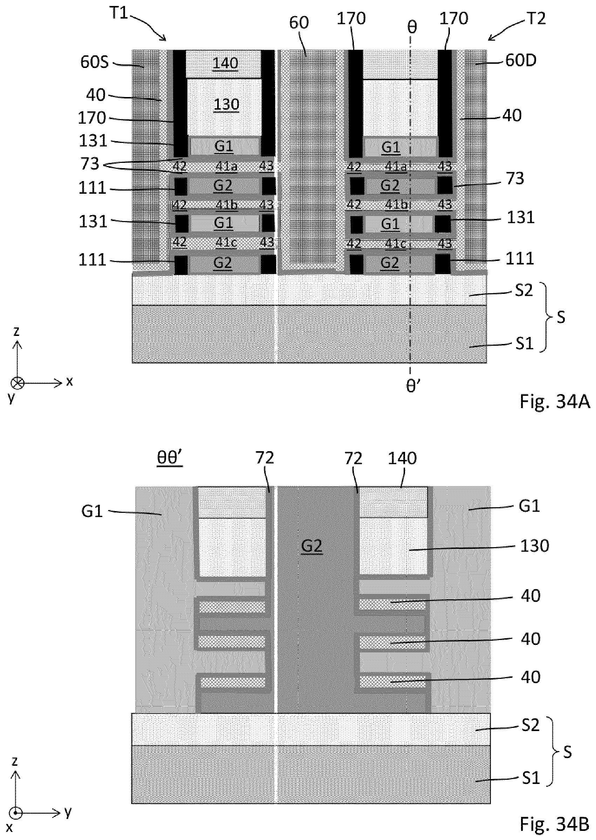

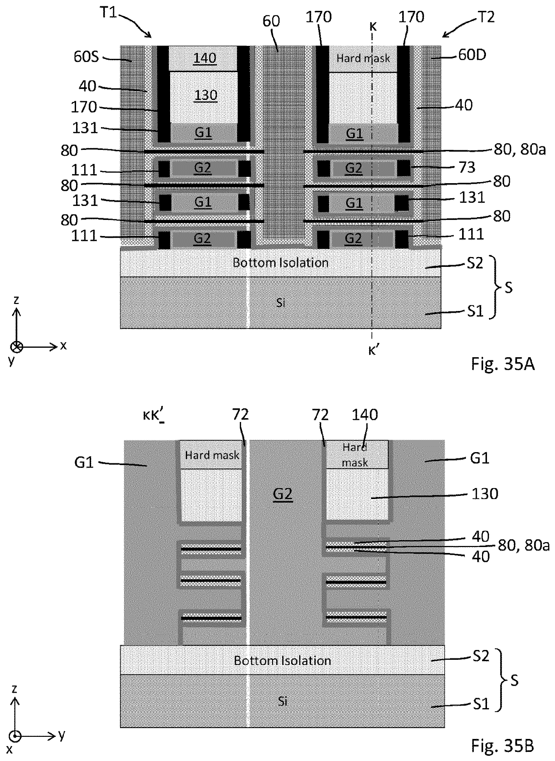

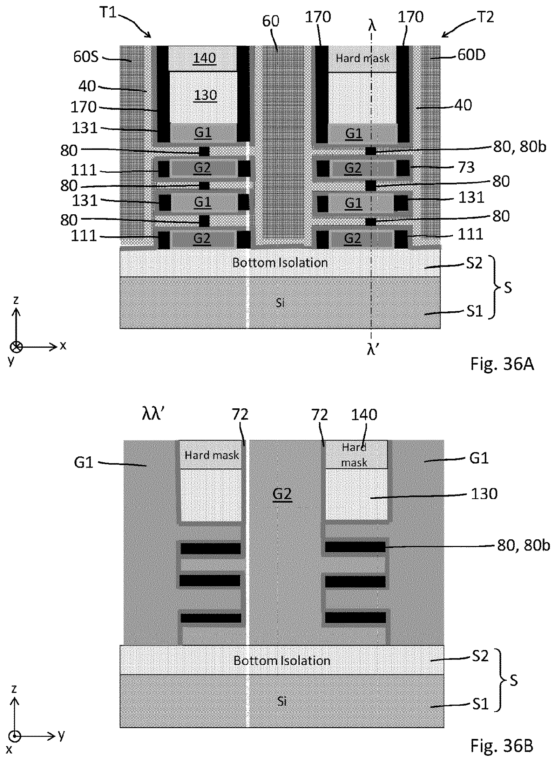

Les figures 23A, 23B à 34A, 34B illustrent schématiquement des étapes de fabrication d'un dispositif comprenant des transistors GAA selon un deuxième mode de réalisation. Les figures nA (n=23...34) correspondent à des premières coupes transverses illustrant chacune une étape différente du procédé de fabrication. Les figures nB (n=23...34) correspondent à des deuxièmes coupes transverses illustrant chacune la même étape que la figure nA correspondante.

Seules les caractéristiques différentes de ce deuxième mode de réalisation vis-à-vis du premier mode de réalisation sont décrites ci-après. Les autres caractéristiques sont réputées identiques à celles du premier mode de réalisation, en référence à ce qui précède. Ce deuxième mode de réalisation peut notamment être qualifié de « channel last ». Les canaux des transistors sont ici formés après remplacement des portions de grille sacrificielle par les première et deuxième grilles.

Comme illustré aux figures 23A, 23B, après formation des espaceurs internes 111, 131, les deuxièmes ouvertures sont remplies par un matériau diélectrique 27, par exemple à base de SiO2. Le masque dur 140 est en partie ouvert pour accéder à certaines portions de la grille sacrificielle 150 via les ouvertures 300a, comme précédemment.

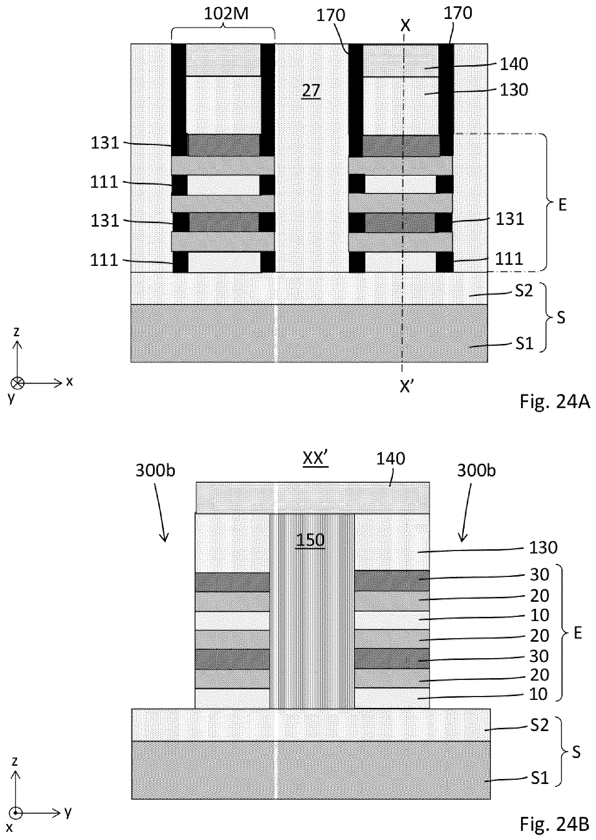

Comme illustré aux figures 24A, 24B, les portions exposées de la grille sacrificielle 150 sont retirées pour former les troisièmes ouvertures 300b, comme précédemment. Les troisièmes ouvertures 300b débouchent sur les parties centrales des troisièmes couches 30.

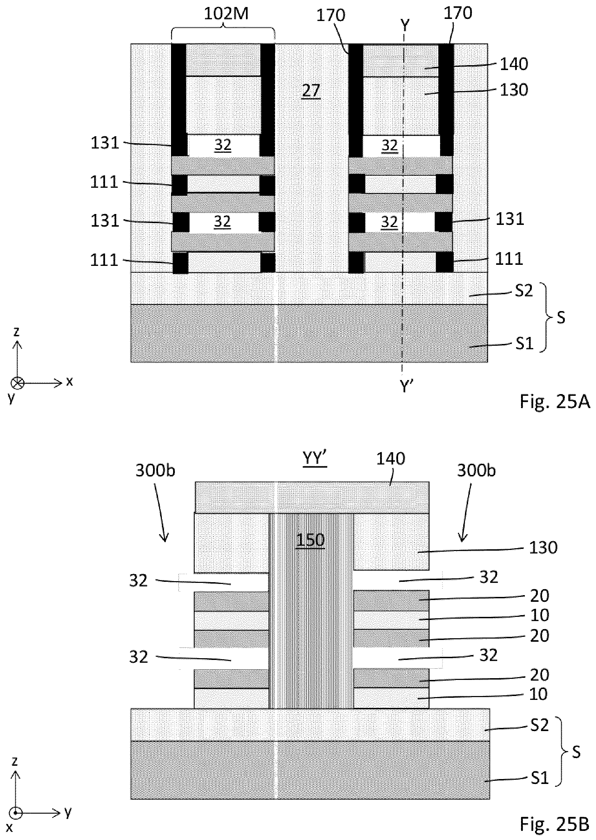

Comme illustré aux figures 25A, 25B, les parties centrales des troisièmes couches 30 sont ensuite totalement retirées par gravure sélective vis-à-vis des deuxièmes couches 20 et des parties centrales des premières couches 10, à partir des troisièmes ouvertures 300b. Cette gravure vise à former des troisièmes cavités 32 à la place des parties centrales des troisièmes couches 30. Cette gravure présente un caractère isotrope et peut être effectuée par voie humide ou par voie sèche, à partir des troisièmes ouvertures 300b.

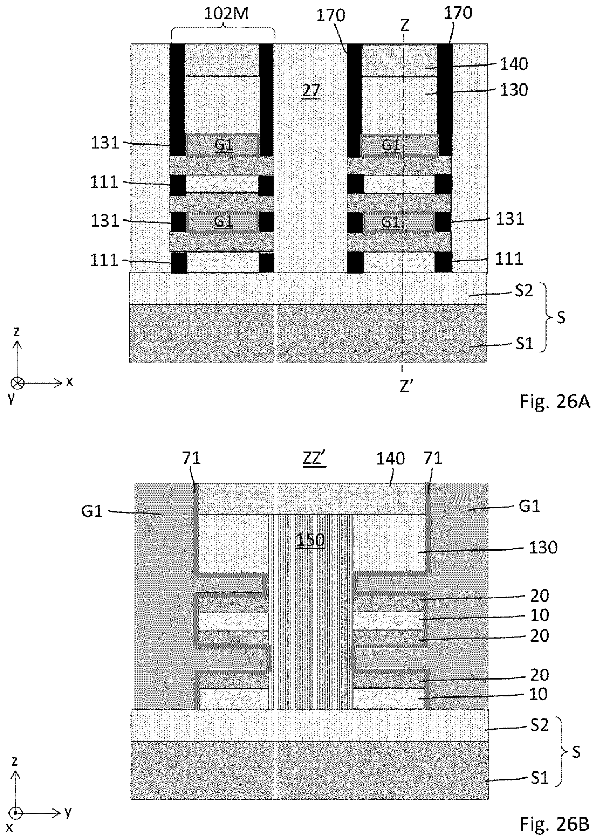

Comme illustré aux figures 26A, 26B, les troisièmes ouvertures 300b et les troisièmes cavités 32 sont ensuite remplies par une ou plusieurs couches métalliques, par exemple à base de TiN, W, afin de former la première grille G1 des transistors GAA. Avant dépôt des couches métalliques, une couche diélectrique 71 à base d'un matériau à forte permittivité, par exemple à base de HfO2, est préalablement déposée de façon à tapisser les troisièmes ouvertures 300b et les troisièmes cavités 32. Cela permet de former la couche diélectrique de grille entre les deuxièmes couches 20, qui forment ultérieurement les canaux des transistors GAA, et la première grille G1. Cela permet également d'isoler la première grille G1 vis-à-vis des premières couches 10, qui forment ultérieurement des doigts de la deuxième grille G2, comme précédemment.

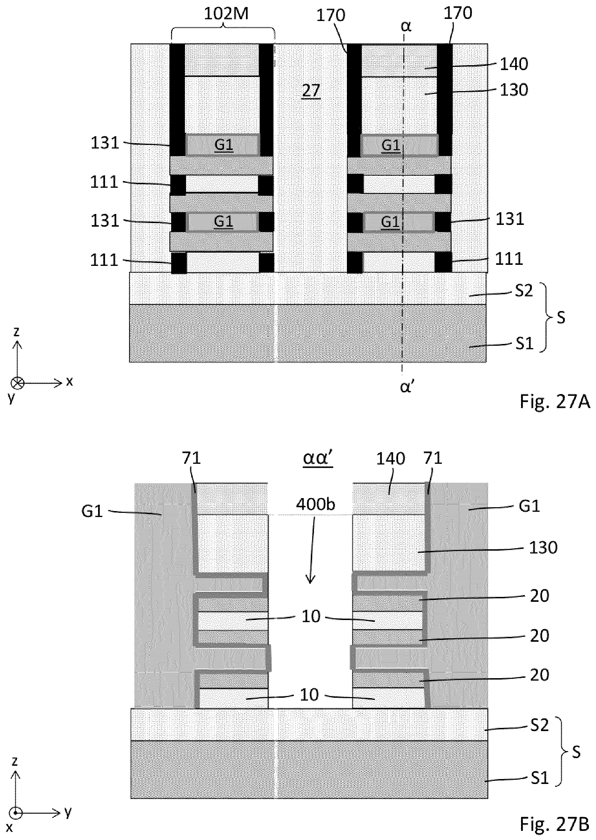

Comme illustré aux figures 27A, 27B, le masque dur 140 est de nouveau en partie ouvert pour accéder aux portions restantes de la grille sacrificielle 150, et les portions restantes de la grille sacrificielle 150 sont retirées pour former les quatrièmes ouvertures 400b, comme précédemment. Les quatrièmes ouvertures 400b débouchent sur les parties centrales des premières couches 10.

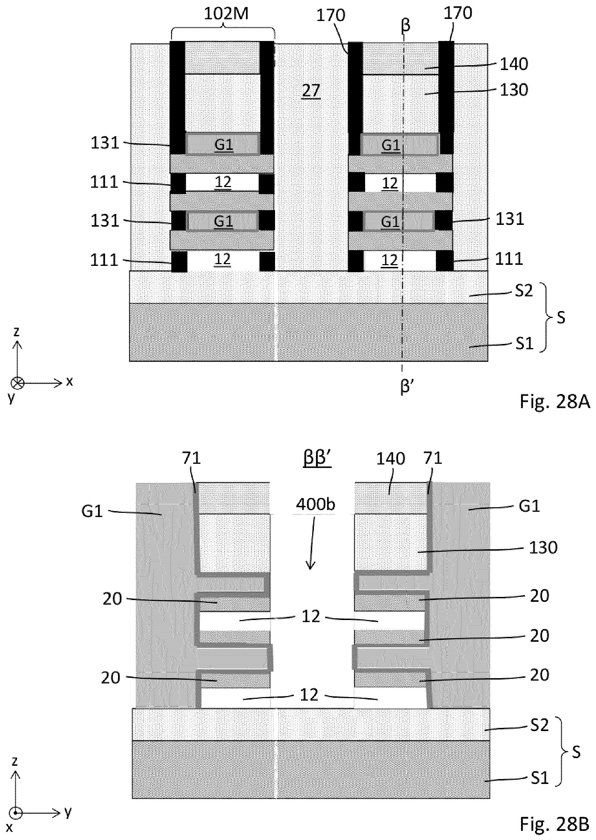

Comme illustré aux figures 28A, 28B, les parties centrales des premières couches 10 sont ensuite totalement retirées par gravure sélective vis-à-vis de la couche diélectrique 71 et des deuxièmes couches 20, à partir des quatrièmes ouvertures 400b. Cette gravure vise à former les premières cavités 12 à la place des parties centrales des premières couches 10.

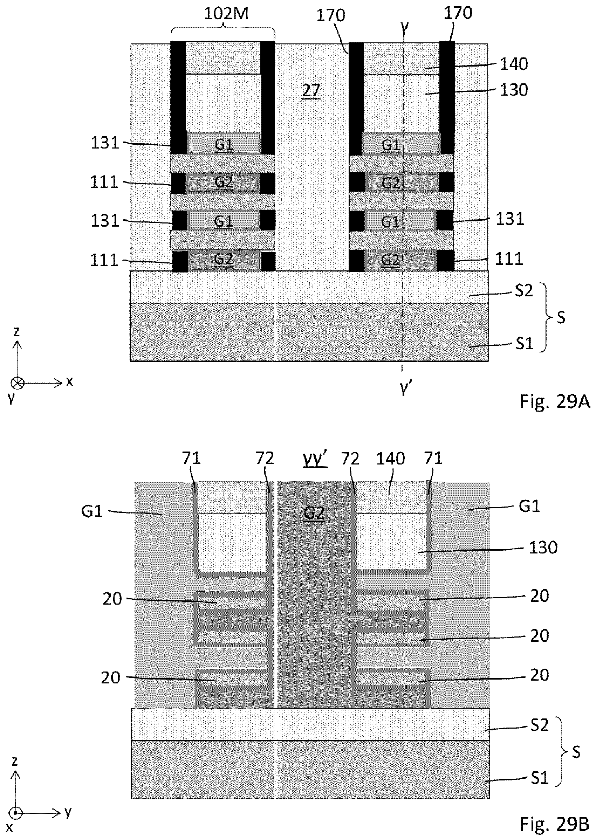

Comme illustré aux figures 29A, 29B, les quatrièmes ouvertures 400b et les premières cavités 12 sont ensuite remplies par une ou plusieurs couches métalliques, par exemple à base de TiN, W, afin de former une deuxième grille G2 des transistors GAA. Avant dépôt des couches métalliques, une couche diélectrique 72 à base d'un matériau à forte permittivité, par exemple à base de HfO2, est préalablement déposée de façon à tapisser les quatrièmes ouvertures 400b et les premières cavités 12. Cela permet de former la couche diélectrique de grille entre les deuxièmes couches 20, qui forment ultérieurement les canaux des transistors GAA, et la deuxième grille G2. Cela permet également d'isoler la deuxième grille G2 vis-à-vis de la première grille G1, comme précédemment.

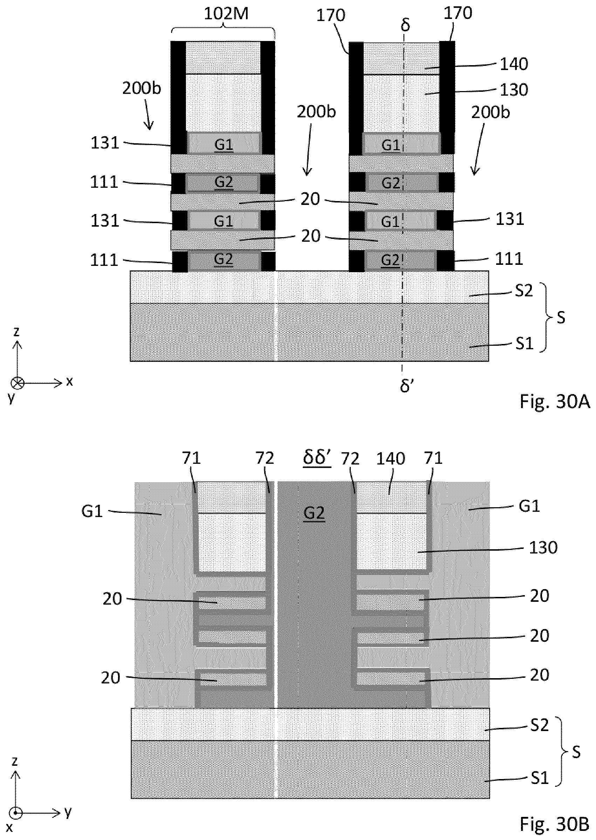

Comme illustré aux figures 30A, 30B, le matériau diélectrique 27 est retiré de façon à reformer les deuxièmes ouvertures 200b. Les deuxièmes ouvertures 200b débouchent sur les deuxièmes couches 20.

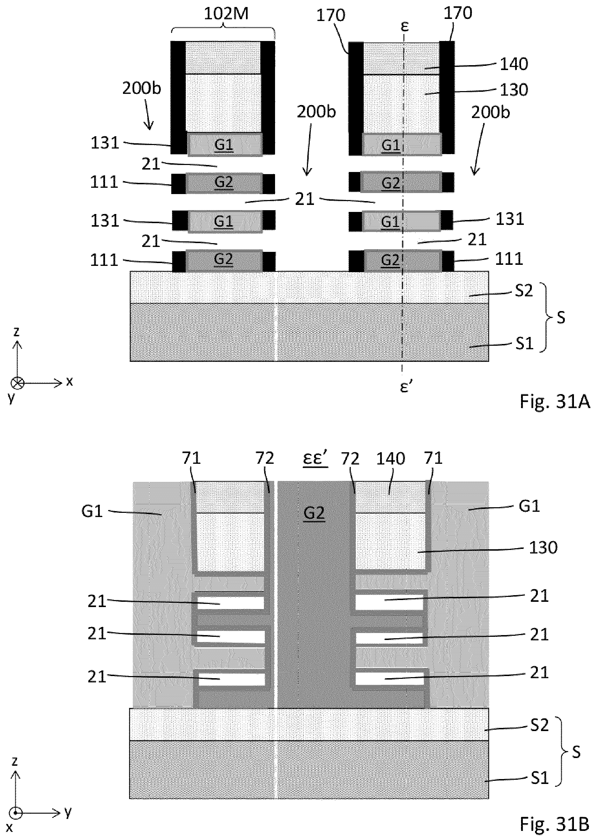

Comme illustré aux figures 31A, 31B, les deuxièmes couches 20 sont ensuite gravées sélectivement vis-à-vis des couches diélectriques 71, 72, à partir des deuxièmes ouvertures 200b. Cette gravure totale peut être arrêtée au temps, possiblement après un temps de surgravure visant à garantir le retrait total du deuxième matériau des deuxièmes couches 20. Cette gravure totale présente un caractère isotrope et peut être effectuée par voie humide ou par voie sèche, à partir des deuxièmes ouvertures 200b. A l'issue de cette gravure, les deuxièmes couches 20 sont retirées totalement pour former des deuxièmes espaces 21, comme précédemment.

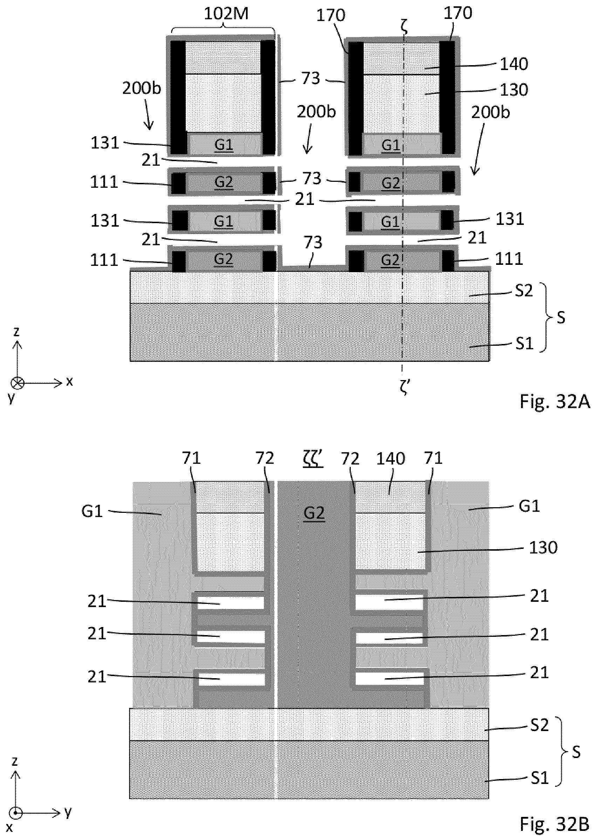

Comme illustré aux figures 32A, 32B, selon une possibilité optionnelle, une couche diélectrique 73 est ensuite déposée dans les deuxièmes espaces 21. Cette couche diélectrique 73 est typiquement à base d'un matériau à forte permittivité, par exemple à base de HfO2. La couche diélectrique 73 peut être formée par dépôt chimique en phase vapeur CVD ou MOCVD, ou par dépôt en couche atomique ALD. La couche diélectrique 73 présente typiquement une épaisseur comprise entre 1 nm et 5 nm. La couche diélectrique 73 permet typiquement d'augmenter l'épaisseur des couches diélectriques de grille formées par les couches diélectriques 71, 72.

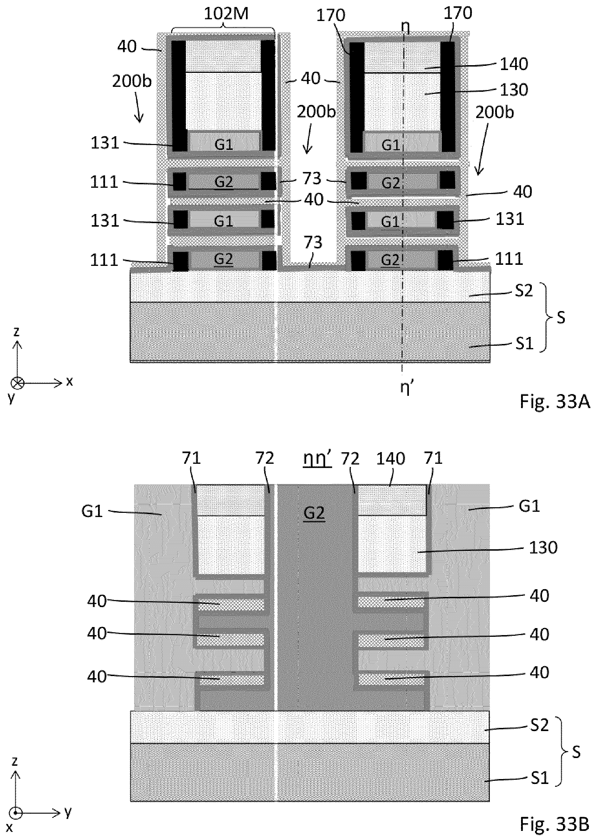

Comme illustré aux figures 33A, 33B, la couche 40 à base d'un matériau semiconducteur est ensuite déposée sur la couche diélectrique 73 dans les deuxièmes espaces 21. Le dépôt du matériau semiconducteur est ici configuré pour que la couche 40 remplisse totalement les deuxièmes espaces 21, comme précédemment. Cette couche 40 est destinée à former les canaux 41 des transistors GAA à l'aplomb des parties centrales des premières couches 10 et des doigts des grilles G1, G2. Cette couche 40 est également destinée à former les sources 42 et les drains 43 des transistors GAA à l'aplomb des espaceurs 170 et des espaceurs internes 111, 131, comme précédemment.

Le matériau semiconducteur de la couche 40 est avantageusement un matériau 2D ou un oxyde semiconducteur, comme précédemment.

Comme illustré aux figures 34A, 34B, les deuxièmes ouvertures peuvent ensuite être remplies par une ou plusieurs couches métalliques 60, afin de former les contacts de source et drain, comme précédemment. Un polissage mécano-chimique CMP est typiquement effectué afin de retirer l'excès de métal déposé sur les motifs 102M.

Un dispositif microélectronique comprenant deux transistors T1, T2 comprenant chacun trois canaux 41a, 41b, 41c empilés selon z, et deux grilles enrobantes G1, G2 interdigitées, est ainsi avantageusement obtenu, comme précédemment. Ce deuxième mode de réalisation du type « channel last » permet de limiter le nombre d'étapes technologiques auxquelles sont exposés les canaux des transistors lors de la formation du dispositif. Les propriétés du matériau formant les canaux des transistors sont ainsi préservées.

Au vu de la description qui précède, il apparaît clairement que le dispositif et le procédé proposés offrent une solution particulièrement efficace pour former des transistors GAA à tension de seuil ajustable. Cette solution est en outre avantageusement compatible avec les procédés standards de la microélectronique. L'invention n'est cependant pas limitée aux modes de réalisations précédemment décrits.

Selon une possibilité non illustrée, la couche 40 à base du matériau semiconducteur ne remplit pas totalement les deuxièmes espaces 21. Dans ce cas, les portions de la couche 40 situées dans les deuxièmes espaces 21 peuvent être significativement plus minces que les deuxièmes couches initiales. Ces portions horizontales peuvent présenter une épaisseur correspondant à quelques couches atomiques seulement, par exemple entre 1 et 5 couches atomiques de matériau semiconducteur. Cela permet de réduire les dimensions des canaux 41 des transistors GAA. Les performances des transistors GAA peuvent être améliorées. Un bouchon diélectrique est typiquement formé entre les portions horizontales de la couche 40, afin de remplir les deuxièmes espaces 21. Cela permet notamment de travailler avec une seule monocouche de matériau 2D. Un excellent contrôle électrostatique du dispositif est ainsi obtenu. La longueur de grille peut ainsi être avantageusement réduite. Cela permet également d'améliorer la résistance mécanique du dispositif et/ou d'éviter des déformations des canaux des transistors GAA, par exemple par échauffement lors du fonctionnement. Ce bouchon diélectrique peut être formé par dépôt CVD et gravure, de façon classique.

## Revendications

1. Dispositif microélectronique comprenant au moins un transistor (T1, T2) comprenant :
• au moins deux canaux (41a, 41b, 41c) empilés selon une direction principale (z), chaque canal étant à base d'un matériau semiconducteur,
• une grille (G1, G2) entourant au moins un des canaux (41a, 41b, 41c),
• une source (42) et un drain (43) de part et d'autre des canaux (41a, 41b, 41c), et des contacts (60S, 60, 60D) de source et de drain connectés respectivement à la source (42) et au drain (43),
• une couche diélectrique (70, 71, 72) de grille séparant chaque canal (41) de la grille (G1),
dans lequel
la grille (G1) correspond à une première grille (G1) entourant partiellement au moins l'un des canaux (41a, 41b, 41c), et en ce que l'au moins un transistor (T1, T2) comprend une deuxième grille (G2) entourant partiellement le même canal que celui entouré par la première grille (G1), les première et deuxième grilles (G1, G2) étant isolées électriquement entre elles, de façon à ce qu'elles puissent être polarisées indépendamment l'une de l'autre, la première grille (G1) et la deuxième grille (G2) étant interdigitées, et chaque canal (41a, 41b, 41c) étant intercalé entre un doigt de la première grille (G1) et un doigt de la deuxième grille (G2), le dispositif **caractérisé en ce que**
la première grille (G1) recouvre deux côtés adjacents de l'un des canaux (41a, 41b, 41c), et la deuxième grille (G2) recouvre deux autres côtés adjacents dudit canal (41a, 41b, 41c).

2. Dispositif selon la revendication précédente dans lequel chaque canal (41a, 41b, 41c) est entouré partiellement par la première grille (G1) et est entouré partiellement par la deuxième grille (G2).

3. Procédé de fabrication d'un dispositif microélectronique selon l'une quelconque des revendications précédentes, ledit procédé comprenant les étapes suivantes :
• Fournir sur un substrat (S) un empilement (E) selon la direction principale (z) comprenant une pluralité de premières couches (10) en un premier matériau, alternées avec une pluralité de deuxièmes couches (20) en un deuxième matériau, alternées avec une pluralité de troisièmes couches (30) en un troisième matériau, les premier, deuxième et troisième matériaux étant différents,
• Former un premier masque de gravure (130) sur cet empilement (E),
• Former dans cet empilement (E) des premières ouvertures (100) définissant des premiers motifs (101M) à l'aplomb du premier masque de gravure (130),
• Former une grille sacrificielle (150) de part et d'autre des premiers motifs (101M), dans les premières ouvertures (100),
• Former un deuxième masque de gravure (140) sur le premier masque de gravure (130) et sur la grille sacrificielle (150), le deuxième masque de gravure (140) étant transverse au premier masque de gravure (130),
• Former dans les premiers motifs (101M) des deuxièmes ouvertures (200) définissant des deuxièmes motifs (102M) à l'aplomb du deuxième masque de gravure (140),
• Retirer partiellement, à partir des deuxièmes ouvertures (200), le troisième matériau des troisièmes couches (30) sélectivement aux premier et deuxième matériaux des premières et deuxièmes couches (10, 20), de sorte à former des troisièmes espaces (31) dans les troisièmes couches (30),
• Remplir les troisièmes espaces (31) par un troisième matériau diélectrique pour former des troisièmes espaceurs internes (131),
• Retirer partiellement, à partir des deuxièmes ouvertures (200), le premier matériau des premières couches (30) sélectivement aux deuxième matériau des deuxièmes couches (20) et aux troisièmes espaceurs internes (131), de sorte à former des premiers espaces (11) dans les premières couches (10), de préférence à l'aplomb des troisièmes espaceurs internes (131),
• Remplir les premiers espaces (11) par un premier matériau diélectrique pour former des premiers espaceurs internes (111),
• Retirer partiellement la grille sacrificielle (150) de sorte à former des troisièmes ouvertures (300b) débouchant sur des parties restantes des troisièmes couches (30),
• Retirer totalement, à partir des troisièmes ouvertures (300b), le troisième matériau des parties restantes des troisièmes couches (30), de sorte à former des troisièmes cavités (32),
• Former une première couche diélectrique (71) dans les troisièmes cavités (32),
• Remplir par un premier matériau métallique les troisièmes cavités (32) et les troisièmes ouvertures (300b), de façon à former la première grille (G1) entourant partiellement les deuxièmes couches (20),
• Retirer totalement une partie restante de la grille sacrificielle (150) de sorte à former des quatrièmes ouvertures (400b) débouchant sur des parties restantes des premières couches (10),
• Retirer totalement, à partir des quatrièmes ouvertures (400b), le premier matériau des parties restantes des premières couches (10), de sorte à former des premières cavités (12),
• Former une deuxième couche diélectrique (72) dans les premières cavités (12),
• Remplir par un deuxième matériau métallique les premières cavités (12) et les quatrièmes ouvertures (400b), de façon à former la deuxième grille (G2) entourant partiellement les deuxièmes couches (20),
• Remplir les deuxièmes ouvertures (200, 200b) par un matériau conducteur électrique de façon à former des contacts de source et de drain au contact des deuxièmes couches (20).

4. Procédé selon la revendication précédente comprenant en outre une séquence d'étapes configurée pour remplacer les deuxièmes couches (20), ladite séquence comprenant les étapes suivantes :
• Retirer totalement, à partir des deuxièmes ouvertures (200, 200b), le deuxième matériau des deuxièmes couches (20), de sorte à former des deuxièmes espaces (21),
• Former de préférence une couche diélectrique (70, 73) dans les deuxièmes espaces (21),
• Déposer une couche (40) à base d'un matériau semiconducteur dans les deuxièmes espaces (21), de sorte à former :
∘ des canaux (41a, 41b, 41c) à base du matériau semiconducteur à l'aplomb des première et deuxième grilles (G1, G2), sous les premier et deuxième masques de gravure (130, 140), et
∘ des sources (42) et drains (43) à base du matériau semiconducteur à l'aplomb des premiers et troisièmes espaceurs internes (111, 131).

5. Procédé selon la revendication précédente dans lequel la séquence d'étapes configurée pour remplacer les deuxièmes couches (20) est effectuée après formation des premiers et troisièmes espaceurs internes (111, 131) et dans lequel la formation des contacts (60, 60S, 60D) de source et de drain est effectuée après ladite séquence d'étapes et avant le retrait partiel de la grille sacrificielle (150).

6. Procédé selon la revendication 4 dans lequel la séquence d'étapes configurée pour remplacer les deuxièmes couches (20) est effectuée après formation des première et deuxième grilles (G1, G2) et avant formation des contacts (60, 60S, 60D) de source et de drain.

7. Procédé selon l'une quelconque des revendications 3 à 6 comprenant en outre une formation d'espaceurs (170) sur des flancs des premier et deuxième masques de gravure (130, 140), lesdits espaceurs (170) prenant appui sur une face supérieure (321) des premiers motifs (101M).

8. Procédé selon l'une quelconque des revendications 4 à 7 dans lequel le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S), le sélénium (Se) ou le tellure (Te).

9. Procédé selon l'une quelconque des revendications 3 à 8 dans lequel les premières couches (10) de l'empilement (E) sont uniquement au contact des deuxièmes couches (20) et dans lequel les troisièmes couches (30) de l'empilement (E) sont uniquement au contact des deuxièmes couches (20).

10. Procédé selon l'une quelconque des revendications 4 à 9 dans lequel le dépôt de la couche (40) à base du matériau semiconducteur est configuré pour que la couche (40) à base du matériau semiconducteur remplisse totalement les deuxièmes espaces (21).

11. Procédé selon l'une quelconque des revendications 4 à 9 dans lequel le dépôt de la couche (40) à base du matériau semiconducteur est configuré pour que la couche (40) à base du matériau semiconducteur remplisse partiellement les deuxièmes espaces (21), ledit procédé comprenant en outre, après dépôt de la couche (40) à base du matériau semiconducteur, un dépôt d'une couche diélectrique additionnelle configuré pour combler les deuxièmes espaces (21).

12. Procédé selon l'une quelconque des revendications 3 à 11 dans lequel les premières ouvertures (100) sont formées selon une direction longitudinale (x) et les deuxièmes ouvertures (200) sont formées selon une direction transversale (y) perpendiculaire à la direction longitudinale (x), lesdites premières et deuxièmes ouvertures (100, 200) s'étendant jusqu'au substrat (S).

13. Procédé selon l'une quelconque des revendications 4 à 12 dans lequel le dépôt de la couche (40) à base du matériau semiconducteur ne remplit pas totalement les deuxièmes espaces (21) de sorte que deux portions horizontales de couche (40) à base du matériau semiconducteur sont formées dans chaque deuxième espace (21), et dans lequel un bouchon diélectrique (80) est formé entre lesdites deux portions horizontales dans chaque deuxième espace (21), afin de remplir chaque deuxième espace (21).

## Patentansprüche

1. Mikroelektronische Vorrichtung, die mindestens einen Transistor (T1, T2) umfasst, der Folgendes umfasst:
• mindestens zwei Kanäle (41a, 41b, 41c), die entlang einer Hauptrichtung (z) gestapelt sind, wobei jeder Kanal auf einem Halbleitermaterial basiert;
• ein Gate (G1, G2), das mindestens einen der Kanäle (41a, 41b, 41c) umgibt,
• eine Source (42) und einen Drain (43) zu beiden Seiten der Kanäle (41a, 41b, 41c) und Source- und Drain-Kontakte (60S, 60, 60D), die jeweils mit der Source (42) und dem Drain (43) verbunden sind,
• eine dielektrische Gate-Schicht (70, 71, 72), die jeden Kanal (41) von dem Gate (G1) trennt,
wobei das Gate G1 einem ersten Gate (G1) entspricht, das teilweise mindestens einen der Kanäle (41a, 41b, 41c) umgibt, und dass mindestens ein Transistor (T1, T2) ein zweites Gate (G2) umfasst, das teilweise denselben Kanal wie den umgibt, der von dem ersten Gate (G1) umgeben ist, wobei das erste und das zweite Gate (G1, G2) voneinander elektrisch derart isoliert sind, dass sie unabhängig voneinander polarisiert werden können, wobei das erste Gate (G1) und das zweite Gate (G2) ineinandergreifen und jeder Kanal (41a, 41b, 41c) zwischen einem Finger des ersten Gates (G1) und einem Finger des zweiten Gates (G2) eingefügt ist, Vorrichtung **dadurch gekennzeichnet, dass** das erste Gate (G1) zwei angrenzende Seiten eines der Kanäle (41a, 41b, 41c) abdeckt, und das zweite Gate (G2) zwei andere angrenzende Seiten des Kanals (41a, 41b, 41c) abdeckt.

2. Vorrichtung nach dem vorstehenden Anspruch, wobei jeder Kanal (41a, 41b, 41c) teilweise von dem ersten Gate (G1) umgeben ist und teilweise von dem zweiten Gate (G2) umgeben ist.

3. Verfahren zur Fertigung einer mikroelektronischen Vorrichtung nach einem der vorstehenden Ansprüche, wobei das Verfahren die folgenden Schritte umfasst:
• Bereitstellen eines Substrats (S) einer Stapelung (E) entlang der Hauptrichtung (z), die eine Vielzahl erster Schichten (10) aus einem ersten Material umfasst, die mit einer Vielzahl zweiter Schichten (20) aus einem zweiten Material abwechselt, die mit einer Vielzahl dritter Schichten (30) aus einem dritten Material abwechselt, wobei sich das erste, zweite und dritte Material unterscheiden,
• Bilden einer ersten Ätzmaske (130) auf dieser Stapelung (E),
• Bilden in dieser Stapelung (E) erster Öffnungen (100), die erste Strukturen (101M) vertikal zu der ersten Ätzmaske (130) definieren,
• Bilden eines Opfergitters (150) zu beiden Seiten der ersten Strukturen (101M) in den ersten Öffnungen (100),
• Bilden einer zweiten Ätzmaske (140) auf der ersten Ätzmaske (130) und auf dem Opfergitter (150), wobei die zweite Ätzmaske (140) zu der ersten Ätzmaske (130) quer steht,
• Bilden in den ersten Strukturen (101M) zweiter Öffnungen (200), die zweite Strukturen (102M) definieren, vertikal zu der zweiten Ätzmaske (140),
• teilweises Entfernen ausgehend von den zweiten Öffnungen (200) des dritten Materials der dritten Schichten (30) selektiv zu dem ersten und dem zweiten Material der ersten und der zweiten Schicht (10, 20) derart, dass dritte Zwischenräume (31) in den dritten Schichten (30) gebildet werden,
• Füllen der dritten Zwischenräume (31) mit einem dritten dielektrischen Material, um dritte interne Abstandhalter (131) zu bilden,
• teilweises Entfernen ausgehend von den zweiten Öffnungen (200) des ersten Materials der ersten Schichten (30) selektiv zu dem zweiten Material der zweiten Schichten (20) und dem dritten internen Abstandhalter (131) derart, dass erste Zwischenräume (11) in den ersten Schichten (10) bevorzugt vertikal zu den dritten Abstandhaltern (131) gebildet werden,
• Füllen der ersten Zwischenräume (11) mit einem dielektrischen Material, um erste interne Abstandhalter (111) zu bilden,
• teilweises Entfernen des Opfergitters (150) derart, dass dritte Öffnungen (300b) gebildet werden, die auf restlichen Teilen der dritten Schichten (30) münden,
• vollständiges Entfernen ausgehend von den dritten Öffnungen (300b) des dritten Materials der restlichen Teile der dritten Schichten (30) derart, dass dritte Zwischenräume (32) gebildet werden,
• Bilden einer ersten dielektrischen Schicht (71) in den dritten Hohlräumen (32),
• Füllen mit einem ersten metallischen Material der dritten Hohlräume (32) und der dritten Öffnungen (300b) derart, dass das erste Gate (G1) gebildet wird, das die zweiten Schichten (20) teilweise umgibt,
• vollständiges Entfernen eines restlichen Teils des Opfergitters (150) derart, dass vierte Öffnungen (400b) gebildet werden, die auf restlichen Teilen der ersten Schichten (10) münden,
• vollständiges Entfernen ausgehend von den vierten Öffnungen (400b) des ersten Materials der restlichen Teile der ersten Schichten (10) derart, dass erste Hohlräume (12) gebildet werden,
• Bilden einer zweiten dielektrischen Schicht (72) in den ersten Hohlräumen (12),
• Füllen mit einem zweiten metallischen Material der ersten Hohlräume (12) und der vierten Öffnungen (400b) derart, dass das zweite Gate (G2) gebildet wird, das die zweiten Schichten (20) teilweise umgibt,
• Füllen der zweiten Öffnungen (200, 200b) mit einem elektrisch leitfähigen Material derart, dass Source- und Drain-Kontakte in Kontakt mit zweiten Schichten (20) gebildet werden.

4. Verfahren nach dem vorstehenden Anspruch, das außerdem eine Folge von Schritten umfasst, die dazu konfiguriert ist, die zweiten Schichten (20) zu ersetzen, wobei die Folge die folgenden Schritte umfasst:
• vollständiges Entfernen ausgehend von den zweiten Öffnungen (200, 200b) des ersten Materials der zweiten Schichten (20) derart, dass zweite Hohlräume (21) gebildet werden,
• Bilden bevorzugt einer dielektrischen Schicht (70, 73) in den zweiten Zwischenräumen (21),
• Abscheiden einer Schicht (40) auf Basis eines Halbleitermaterials in den zweiten Zwischenräumen (21) derart, dass Folgendes gebildet wird:
∘ Kanäle (41a, 41b, 41c) auf Basis des Halbleitermaterials vertikal zu dem ersten und dem zweiten Gate (G1, G2) unter der ersten und der zweiten Ätzmaske (130, 140), und
∘ Sourcen (42) und Drains (43) auf Basis des Halbleitermaterials, senkrecht zu den ersten und dritten internen Abstandhaltern (111, 131).

5. Verfahren nach dem vorstehenden Anspruch, wobei die Folge von Schritten, die zum Ersetzen der zweiten Schichten (20) konfiguriert ist, nach Bilden des ersten und des dritten internen Abstandhalters (111, 131) erfolgt, und wobei das Bilden der Source- und Drain-Kontakte (60, 60S, 60D) nach der Folge von Schritten und vor dem teilweisen Entfernen des Opfergitters (150) erfolgt.

6. Verfahren nach Anspruch 4, wobei die Folge von Schritten, die zum Ersetzen der zweiten Schichten (20) konfiguriert ist, nach dem Bilden des ersten und des zweiten Gates (G1, G2) und vor dem Bilden der Source- und Drain-Kontakte (60, 60S, 60D) erfolgt.

7. Verfahren nach einem der Ansprüche 3 bis 6, das außerdem ein Bilden von Abstandhaltern (170) auf Flanken der ersten und der zweiten Ätzmaske (130, 140) umfasst, wobei die Abstandhalter (170) auf einer oberen Fläche (321) der ersten Strukturen (101M) aufliegen.

8. Verfahren nach einem der Ansprüche 4 bis 7, wobei das Halbleitermaterial ein zweidimensionales Material (2D-Material) ist, das ausgewählt wird aus Übergangsmetall-Dichalkogeniden MX2 mit M ausgewählt aus Molybdän (Mo) oder Wolfram (W) und X ausgewählt aus Schwefel (S), Selen (Se) oder Tellur (Te).

9. Verfahren nach einem der Ansprüche 3 bis 8, wobei die ersten Schichten (10) der Stapelung (E) ausschließlich mit zweiten Schichten (20) in Kontakt sind, und wobei die dritten Schichten (30) der Stapelung (E) ausschließlich mit zweiten Schichten (20) in Kontakt sind.

10. Verfahren nach einem der Ansprüche 4 bis 9, wobei das Abscheiden der Schicht (40) auf Basis des Halbleitermaterials dazu konfiguriert ist, dass die Schicht (40) auf Basis des Halbleitermaterials die zweiten Zwischenräume (21) vollständig füllt.

11. Verfahren nach einem der Ansprüche 4 bis 9, wobei das Abscheiden der Schicht (40) auf Basis des Halbleitermaterials dazu konfiguriert ist, dass die Schicht (40) auf Basis des Halbleitermaterials die zweiten Zwischenräume (21) teilweise füllt, wobei das Verfahren außerdem nach dem Abscheiden der Schicht (40) auf Basis des Halbleitermaterials ein Abscheiden einer zusätzlichen dielektrischen Schicht umfasst, die dazu konfiguriert ist, die zweiten Zwischenräume (21) aufzufüllen.

12. Verfahren nach einem der Ansprüche 3 bis 11, wobei die ersten Öffnungen (100) gemäß einer Längsrichtung (x) gebildet sind, und die zweiten Öffnungen (200) gemäß einer Querrichtung (y) senkrecht zu der Längsrichtung (x) gebildet sind, wobei sich die ersten und die zweiten Öffnungen (100, 200) bis zu dem Substrat (S) erstrecken.

13. Verfahren nach einem der Ansprüche 4 bis 12, wobei das Abscheiden der Schicht (40) auf Basis des Halbleitermaterials die zweiten Zwischenräume (21) nicht vollständig füllt, sodass zwei horizontale Schichtteile (40) auf Basis des Halbleitermaterials in jedem zweiten Zwischenraum (21) gebildet werden, und wobei ein dielektrischer Stopfen (80) zwischen zwei horizontalen Teilen in jedem zweiten Zwischenraum (21) gebildet wird, um jeden zweiten Zwischenraum (21) zu füllen.

## Claims

1. Microelectronic device comprising at least one transistor (T1, T2) comprising:
• at least two channels (41a, 41b, 41c) stacked along a main direction (z), each channel being with the basis of a semiconductive material,
• a gate (G1, G2) surrounding at least one of the channels (41a, 41b, 41c),
• a source (42) and a drain (43) either side of the channels (41a, 41b, 41c), and source and drain contacts (60S, 60, 60D) connected respectively to the source (42) and to the drain (43),
• a gate dielectric layer (70, 71, 72) separating each channel (41) of the gate (G1),
wherein the gate (G1) corresponds to a first gate (G1) partially surrounding at least one of the channels (41a, 41b, 41c), and in that the at least one transistor (T1, T2) comprises a second gate (G2) partially surrounding the same channel as that surrounded by the first gate (G1), the first and second gates (G1, G2) being electrically isolated from one another, such that they can be biased independently of one another, the first gate (G1) and the second gate (G2) being interdigitated, and each channel (41a, 41b, 41c) being inserted between a finger of the first gate (G1) and a finger of the second gate (G2), the device **characterised in that** the first gate (G1) covers two adjacent sides of one of the channels (41a, 41b, 41c), and the second gate (G2) covers two other adjacent sides of said channel (41a, 41b, 41c).

2. Device according to the preceding claim, wherein each channel (41a, 41b, 41c) is partially surrounded by the first gate (G1) and is partially surrounded by the second gate (G2).

3. Method for manufacturing a microelectronic device according to any one of the preceding claims, said method comprising the following steps:
• Providing, on a substrate (S), a stack (E) along the main direction (z) comprising a plurality of first layers (10) made of a first material, alternated with a plurality of second layers (20) made of a second material, alternated with a plurality of third layers (30) made of a third material, the first, second and third materials being different,
• Forming a first etching mask (130) on this stack (E),
• Forming, in this stack (E), first openings (100) defining first patterns (101M) in vertical alignment with the first etching mask (130),
• Forming a sacrificial gate (150) either side of the first patterns (101M), in the first openings (100),
• Forming a second etching mask (140) on the first etching mask (130) and on the sacrificial gate (150), the second etching mask (140) being transverse to the first etching mask (130),
• Forming, in the first patterns (101M), second openings (200) defining second patterns (102M) in vertical alignment with the second etching mask (140),
• Partially removing, from the second openings (200), the third material of the third layers (30) selectively at the first and second material of the first and second layers (10, 20), so as to form third spaces (31) in the third layers (30),
• Filling the third spaces (31) with a third dielectric material to form third internal spacers (131),
• Partially removing, from the second openings (200), the first material of the first layers (30) selectively at the second material of the second layers (20) and at the third internal spacers (131), so as to form first spaces (11) in the first layers (10), preferably in vertical alignment with the third internal spacers (131),
• Filling the first spaces (11) with a first dielectric material to form first internal spacers (111),
• Partially removing the sacrificial gate (150) so as to form third openings (300b) opening onto the remaining parts of the third layers (30),
• Totally removing, from the third openings (300b), the third material of the remaining parts of the third layers (30), so as to form third cavities (32),
• Forming a first dielectric layer (71) in the third cavities (32),
• Filling the third cavities (32) and the third openings (300b) with a first metal material, so as to form the first gate (G1) partially surrounding the second layers (20),
• Totally removing a remaining part of the sacrificial gate (150), so as to form fourth openings (400b) opening onto the remaining parts of the first layers (10),
• Totally removing, from the fourth openings (400b), the first material of the remaining parts of the first layers (10), so as to form first cavities (12),
• Forming a second dielectric layer (72) in the first cavities (12),
• Filling the first cavities (12) and the fourth openings (400b) with a second metal material, so as to form the second gate (G2) partially surrounding the second layers (20),
• Filling the second openings (200, 200b) with an electrically conductive material, so as to form source and drain contacts in contact with the second layers (20).

4. Method according to the preceding claim, further comprising a sequence of steps configured to replace the second layers (20), said sequence comprising the following steps:
• Totally removing, from the second openings (200, 200b), the second material of the second layers (20), so as to form second spaces (21),
• Preferably forming a dielectric layer (70, 73) in the second spaces (21),
• Depositing a layer (40) with the basis of a semiconductive material in the second spaces (21), so as to form:
∘ channels (41a, 41b, 41c) with the basis of the semiconductive material in vertical alignment with the first and second gates (G1, G2), under the first and second etching masks (130, 140), and
∘ sources (42) and drains (43) with the basis of the semiconductive material in vertical alignment with the first and third internal spacers (111, 131).

5. Method according to the preceding claim, wherein the sequence of steps configured to replace the second layers (20) is carried out after formation of the first and third internal spacers (111, 131), and wherein the formation of the source and drain contacts (60, 60S, 60D) is done after said sequence of steps and before the partial removal of the sacrificial gate (150).

6. Method according to claim 4, wherein the sequence of steps configured to replace the second layers (20) is carried out after formation of the first and second gates (G1, G2) and before formation of the source and drain contacts (60, 60S, 60D).

7. Method according to any one of claims 3 to 6 further comprising a formation of spacers (170) on the flanks of the first and second etching masks (130, 140), said spacers (170) bearing on an upper face (321) of the first patterns (101M).

8. Method according to any one of claims 4 to 7, wherein the semiconductive material is a two-dimensional (2D) material chosen from among MX2 transition metal chalcogenides, with M taken from among molybdenum (Mo) or tungsten (W), and X taken from among sulphur (S), selenium (Se) or tellurium (Te).

9. Method according to any one of claims 3 to 8, wherein the first layers (10) of the stack (E) are only in contact with the second layers (20), and wherein the third layers (30) of the stack (E) are only in contact with the second layers (20).

10. Method according to any one of claims 4 to 9, wherein the deposition of the layer (40) with the basis of the semiconductive material is configured, such that the layer (40) with the basis of the semiconductive material totally fills the second spaces (21).

11. Method according to any one of claims 4 to 9, wherein the deposition of the layer (40) with the basis of the semiconductive material is configured, such that the layer (40) with the basis of the semiconductive material partially fills the second spaces (21), said method further comprising, after deposition of the layer (40) with the basis of the semiconductive material, a deposition of an additional dielectric layer, configured to fill the second spaces (21).

12. Method according to any one of claims 3 to 11, wherein the first openings (100) are formed along a longitudinal direction (x) and the second openings (200) are formed along a transverse direction (y) perpendicular to the longitudinal direction (x), said first and second openings (100, 200) extending to the substrate (S).

13. Method according to any one of claims 4 to 12, wherein the deposition of the layer (40) with the basis of the semiconductive material does not totally fill the second spaces (21), such that two layer horizontal portions (40) with the basis of the semiconductive material are formed in each second space (21), and wherein a dielectric stopper (80) is formed between said two horizontal portions in each second space (21), in order to fill each second space (21).
